# EUROPEAN PATENT APPLICATION

(11) **EP 4 462 983 A1**
(43) Date of publication of application: **13.11.2024**
(21) Application number: 24174860.7
(22) Date of filing: 08.05.2024
(51) Int. Cl.: H10K 59/121, H10K 59/122, H10K 59/80

(54) **DISPLAY DEVICE**

(30) Priority: 09.05.2023 KR 20230060100
(71) Applicant: Samsung Display Co., Ltd., Gyeonggi-Do (KR)
(72) Inventor: PARK, Juchan, Yongin-si (KR); KIM, Sunho, Yongin-si (KR); KO, Yoomin, Yongin-si (KR); KIM, Hyewon, Yongin-si (KR); SON, Yerim, Yongin-si (KR); CHOI, Chung Sock, Yongin-si (KR)
(74) Representative: Marks & Clerk LLP

(57) **Abstract**

A display device includes light emitting devices each including a first electrode, a second electrode, and an intermediate layer disposed between the first electrode and the second electrode and including a light emitting layer, a pixel definition layer provided with light emitting openings, each of the plurality of light emitting openings to overlap the light emitting layer of a corresponding one of the plurality of the light emitting devices, a separator disposed on the pixel definition layer and provided with division openings to respectively overlap the light emitting openings, and a spacer disposed on the pixel definition layer. The second electrode of each of the light emitting devices may be electrically separated from each other by the separator, and the spacer may overlap a portion of the separator in a plan view.

## Description

### BACKGROUND

### 1. Technical Field

The disclosure relates to a display device with improved process reliability.

### 2. Description of the Related Art

Multimedia electronic devices, such as televisions, mobile phones, tablet computers, computers, navigation devices, and game devices include a display device displaying images.

The display device includes light emitting devices and a circuit to drive the light emitting devices. The light emitting devices included in the display device emit a light in response to voltages applied thereto from the circuit and generate the images. Research on connections between the light emitting devices and the circuit to improve reliability of the display device are in progress. In addition, research is being conducted to reduce defects occurring in processes and to improve a reliability of the display device.

### SUMMARY

The disclosure provides a display device with improved process reliability and reduced defects in light emission.

Embodiments of the inventive concept provide a display device that includes a plurality of light emitting devices each including a first electrode, a second electrode, and an intermediate layer disposed between the first electrode and the second electrode and including a light emitting layer, a pixel definition layer comprising a plurality of light emitting openings, each of the plurality of light emitting openings overlap the light emitting layer of a corresponding one the plurality of light emitting devices, a separator disposed on the pixel definition layer and comprising a plurality of division openings, each of the plurality of division openings overlap a corresponding one the plurality of light emitting openings, and at least one spacer disposed on the pixel definition layer. The second electrode of each of the plurality of light emitting devices overlaps a corresponding one of the plurality of division openings, and is electrically separated from each other by the separator, and the at least one spacer overlaps a portion of the separator in a plan view.

The at least one spacer may be disposed between the pixel definition layer and the separator.

An entire area of at least one spacer may overlap the separator in a plan view.

The at least one spacer may be partially exposed without being covered by the separator in a plan view.

The separator may include a lower surface adjacent to the pixel definition layer and an upper surface opposite to the lower surface and having a width greater than a width of the lower surface in a cross-sectional view, and the at least one spacer may have a width equal to or greater than the width of the lower surface of the separator.

The separator may include a lower surface adjacent to the pixel definition layer and an upper surface opposite to the lower surface, and a distance between the pixel definition layer and a portion of the upper surface of the separator that overlaps the at least one spacer may be greater than a distance between the pixel definition layer and a portion of the upper surface of the separator that does not overlap the at least one spacer.

The at least one spacer may be disposed on the separator, and an entire area of the at least one spacer may overlap the separator in a plan view.

The separator may include a lower surface adjacent to the pixel definition layer and an upper surface opposite to the lower surface and having a width greater than a width of the lower surface in a cross-sectional view, and the at least one spacer may have a width equal to or smaller than a width of the upper surface of the separator in a cross-sectional view.

The separator may include a division mesh line defining the plurality of division openings, the division mesh line may include a plurality of first lines extending in a first direction and a plurality of second lines extending in a second direction, and the separator may include a plurality of intersecting portions where ones of the plurality of first lines intersect ones of the plurality of second lines.

The at least one spacer may overlap one of the plurality of intersecting portions.

The plurality of intersecting portions may include at least one first intersecting portion having a cross shape in a plan view and at least one second intersecting portion having a T-shape in a plan view.

The at least one spacer may overlap the at least one first intersecting portion, and the at least one spacer may have a quadrangular shape or a cross shape in a plan view.

The at least one first intersecting portion may include a first intersecting area, first-first and first-second line areas of each of the plurality of first lines extending from the first intersecting area to directions opposite to each other in the first direction, second-first and second-second line areas of each of the plurality of second lines extending from the first intersecting area to directions opposite to each other in the second direction, and first protruding areas protruding from corresponding line areas adjacent to each other among the first-first, first-second, second-first, and second-second line areas, and the at least one spacer may overlap at least a portion of each of the first intersecting area, the first-first and first-second line areas, the second-first and second-second line areas, and the first protruding areas.

The at least one spacer may overlap the at least one second intersecting portion, and the at least one spacer may have a quadrangular shape, a T-shape, or a triangular shape in a plan view.

The at least one second intersecting portion may include a second intersecting area, a first-third line area of each of the plurality of first lines extending from the second intersecting area in the first direction, second-third and second-fourth line areas of each of the plurality of second lines extending from the second intersecting area to directions opposite to each other in the second direction, and second protruding areas protruding from corresponding line areas adjacent to each other among the first-third, second-third, and second-fourth line areas, and the at least one spacer may overlap at least a portion of each of the second intersecting area, the first-third line area, the second-third and second-fourth line areas, and the second protruding areas.

Each of the at least one first intersecting portion and the at least one second intersecting portion may be provided in plural, the at least one spacer may be provided in plural, and each of the plurality of first intersecting portions and the plurality of second intersecting portions may overlap a corresponding one of the plurality of spacers.

Each of the at least one first intersecting portion and the at least one second intersecting portion may be provided in plural, the at least one spacer may be provided in plural, some of the plurality of first intersecting portions and some of the plurality of second intersecting portions may overlap ones of the plurality of spacers, respectively, and the others of the plurality of first intersecting portions and the others of the plurality of second intersecting portions may not overlap any of the plurality of spacers.

The at least one spacer may be provided in plural, each of the plurality of spacers may include a first spacer and a second spacer, the first spacer may overlap one of the plurality of intersecting portions, and the second spacer may be spaced apart from each of the plurality of intersecting portions and may overlap one of the plurality of first lines and the plurality of second lines.

The separator may further include a bending portion, and the bending portion may include a bending area, a first-fourth line area of each of the plurality of first lines extending from the bending area in the first direction, and a second-fifth line area of each of the plurality of second lines extending from the bending area in the second direction.

The at least one spacer may overlap the bending portion in a plan view.

The at least one spacer overlapping the bending portion may have an L-shape.

The at least one spacer may be provided in plural, each of the plurality of spacers may include a first spacer and a second spacer, the first spacer may overlap one of the plurality of intersecting portions, and the second spacer may be spaced apart from each of the plurality of intersecting portions and may overlap the bending portion.

The at least one spacer may be provided in plural, each of the plurality of spacers may include a first spacer and a second spacer, the first spacer may be spaced apart from the plurality of intersecting portions and may overlap one of the plurality of first lines and the plurality of second lines, and the second spacer may be spaced apart from the plurality of intersecting portions and may overlap the bending portion.

The at least one spacer may be provided in plural, and each of the plurality of spacers may be spaced apart from the each of plurality of intersecting portions and may overlap one of the plurality of first lines and the plurality of second lines.

The at least one spacer may include an organic material.

The organic material may include polyimide.

The display device may further include a first dummy layer disposed on the separator and spaced apart from the intermediate layer of each of the light emitting devices, the first dummy layer and the intermediate layer of each of the plurality of light emitting devices may include a same material, and a second dummy layer disposed on the first dummy layer and spaced apart from the second electrode of each of the plurality of light emitting devices, the second dummy layer and the second electrode of each of the plurality of light emitting devices may include a same material.

The display device may further include a plurality of transistors, each of the plurality of transistors is electrically connected to the second electrode of a corresponding one the plurality of light emitting devices, and a plurality of connection wirings, each of the plurality of connection wirings electrically connecting a corresponding one of the plurality of transistors to the second electrode of a corresponding one of the plurality of light emitting devices. Each of the connection wirings may include a light emitting connection part electrically connected to a corresponding second electrode of one of the plurality of light-emitting devices and spaced apart from a corresponding one of the plurality of light emitting openings, and a driver connection part electrically connected to a corresponding transistor among the plurality of transistors.

At least some of the above and other features of the invention are set out in the claims.

According to the above, the at least one spacer is disposed to overlap the separator that electrically disconnects cathodes of pixels from each other. Thus, defects of the separator occurring in a process of forming the light emitting layer of the plurality of light emitting devices may be reduced. Accordingly, the process reliability may be improved, and the display device with reduced defects in light emission may be provided.

### BRIEF DESCRIPTION OF THE DRAWINGS

The above and other advantages of the disclosure will become readily apparent by reference to the following detailed description in the case that they are considered in conjunction with the accompanying drawings wherein:
FIG. 1 is a schematic block diagram of a display device according to an embodiment of the disclosure;
FIGS. 2A and 2B are schematic diagrams of equivalent circuits of pixels according to embodiments of the disclosure;
FIGS. 3A and 3B are plan views of display panels according to embodiments of the disclosure;
FIGS. 4A to 4C are enlarged plan views of some areas of a display panel according to an embodiment of the disclosure;
FIG. 5 is an enlarged schematic cross-sectional view of an area of the display panel taken along line I-I' of FIG. 4B according to an embodiment of the disclosure;
FIG. 6A is an enlarged schematic cross-sectional view of an area AA of the display panel of FIG. 5 according to an embodiment of the disclosure;
FIG. 6B is an enlarged plan view of an area BB of the display panel of FIG. 5 according to an embodiment of the disclosure;
FIG. 7 is an enlarged schematic cross-sectional view of an area of a display panel taken along line I-I' of FIG. 4B according to an embodiment of the disclosure;
FIG. 8 is an enlarged plan view of a portion of a display panel according to an embodiment of the disclosure;
FIG. 9A is an enlarged schematic cross-sectional view of an area of the display panel taken along line II-II' of FIG. 8 according to an embodiment of the disclosure;
FIG. 9B is an enlarged schematic cross-sectional view of an area of the display panel taken along line III-III' of FIG. 8 according to an embodiment of the disclosure;
FIG. 10A is an enlarged schematic cross-sectional view of an area of the display panel taken along line II-II' of FIG. 8 according to an embodiment of the disclosure;
FIG. 10B is an enlarged schematic cross-sectional view of an area of the display panel taken along line III-III' of FIG. 8 according to an embodiment of the disclosure;
FIGS. 11A to 11C are enlarged plan views of an area of a display panel according to embodiments of the disclosure;
FIGS. 12A to 12C are enlarged plan views of an area of a display panel according to embodiments of the disclosure;
FIG. 13 is an enlarged plan view of an area of a display panel according to an embodiment of the disclosure;
FIG. 14 is an enlarged schematic cross-sectional view of an area of the display panel taken along line IV-IV' of FIG. 13 according to an embodiment of the disclosure;
FIG. 15 is an enlarged plan view of an area of a display panel according to an embodiment of the disclosure;
FIG. 16 is an enlarged plan view of an area of a display panel according to an embodiment of the disclosure;
FIG. 17 is an enlarged plan view of an area of a display panel according to an embodiment of the disclosure;
FIG. 18 is an enlarged plan view of an area of a display panel according to an embodiment of the disclosure;
FIG. 19 is an enlarged plan view of an area of a display panel according to an embodiment of the disclosure; and
FIG. 20 is an enlarged plan view of an area of a display panel according to an embodiment of the disclosure.

### DETAILED DESCRIPTION OF THE EMBODIMENTS

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing example features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another. For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the example term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," in the case that they are used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, parts, and/or modules. Those skilled in the art will appreciate that these blocks, parts, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, parts, and/or modules being implemented by microprocessors or other similar hardware, they may be programmed and controlled using software (e.g., microcode) to perform various functions discussed herein and may optionally be driven by firmware and/or software. It is also contemplated that each block, part, and/or module may be implemented by dedicated hardware, or as a combination of dedicated hardware to perform some functions and a processor (e.g., one or more programmed microprocessors and associated circuitry) to perform other functions. Also, each block, part, and/or module of some embodiments may be physically separated into two or more interacting and discrete blocks, parts, and/or modules without departing from the scope of the inventive concepts. Further, the blocks, parts, and/or modules of some embodiments may be physically combined into more complex blocks, parts, and/or modules without departing from the scope of the inventive concepts.

Hereinafter, embodiments of the disclosure will be described with reference to accompanying drawings.

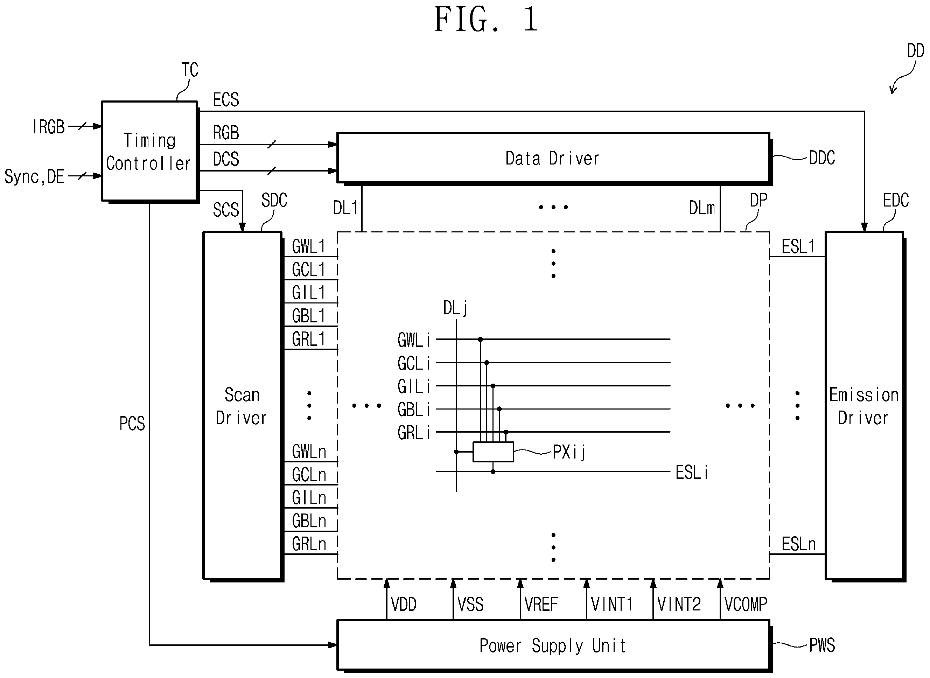

FIG. 1 is a schematic block diagram of a display device DD according to an embodiment of the disclosure. Referring to FIG. 1, the display device DD may include a display panel DP, panel drivers SDC, EDC, and DDC, a power supply part PWS, and a timing controller TC. In the embodiment, the display panel DP may be a light-emitting type display panel. The light-emitting type display panel DP may be an organic light emitting display panel, an inorganic light emitting display panel, or a quantum dot light emitting display panel. In the following descriptions, the organic light emitting display panel will be described in detail as the display panel DP. The panel drivers SDC, EDC, and DDC may include a scan driver SDC, an emission driver EDC, and a data driver DDC.

The display panel DP may include scan lines GWL1 to GWLn, GCL1 to GCLn, GIL1 to GILn, GBL1 to GBLn, and GRL1 to GRLn, emission lines ESL1 to ESLn, and data lines DL1 to DLm. The display panel DP may include multiple pixels electrically connected to the scan lines GWL1 to GWLn, GCL1 to GCLn, GIL1 to GILn, GBL1 to GBLn, and GRL1 to GRLn, the emission lines ESL1 to ESLn, and the data lines DL1 to DLm. Each of "m" and "n" may be an integer number greater than 1.

As an example, a pixel PXij ("i" may be an integer number greater than 1 and less than or equal to n , and "j" may be an integer number greater than 1 and less than or equal to m)positioned to correspond to an i-th horizontal line (or an i-th pixel row) and a j-th vertical line (or a j-th pixel column) may be electrically connected to an i-th first scan line (or a write scan line) GWLi, an i-th second scan line (or a compensation scan line) GCLi, an i-th third scan line (or a first initialization scan line) GILi, an i-th fourth scan line (or a second initialization scan line) GBLi, an i-th fifth scan line (or a reset scan line) GRLi, a j-th data line DLj, and an i-th emission line ESLi.

The pixel PXij may include multiple light emitting devices, multiple transistors, and multiple capacitors. The pixel PXij may receive a first power supply voltage VDD, a second power supply voltage VSS, a third power supply voltage (or a reference voltage) VREF, a fourth power supply voltage (or a first initialization voltage) VINT 1, a fifth power supply voltage (or a second initialization voltage) VINT2, and a sixth power supply voltage (or a compensation voltage) VCOMP from the power supply part PWS.

The first power supply voltage VDD and the second power supply voltage VSS may have a voltage value set to allow a current to flow through a light emitting device and to emit a light. As an example, the first power supply voltage VDD may be set to have a voltage level higher than that of the second power supply voltage VSS.

The third power supply voltage VREF may be a voltage to initialize a gate of a driving transistor included in the pixel PXij. The third power supply voltage VREF may be used to implement a grayscale using a difference in voltage between the third power supply voltage VREF and a data signal. To this end, the third power supply voltage VREF may be set to a voltage within a voltage range of the data signal.

The fourth power supply voltage VINT1 may be used to initialize the capacitor included in the pixel PXij. The fourth power supply voltage VINT1 may be set to a voltage level lower than that of the third power supply voltage VREF. As an example, the fourth power supply voltage VINT1 may be set to a voltage level lower than a difference between the third power supply voltage VREF and a threshold voltage of the driving transistor, however, the disclosure should not be limited thereto or thereby.

The fifth power supply voltage VINT2 may be used to initialize a cathode of the light emitting device included in the pixel PXij. The fifth power supply voltage VINT2 may be set to a voltage level lower than that of the first power supply voltage VDD or the fourth power supply voltage VINT1 or may be set to a voltage level similar to or equal to the third power supply voltage VREF, however, the disclosure should not be limited thereto or thereby. According to an embodiment, the fifth power supply voltage VINT2 may be set to a voltage level similar to or equal to the first power supply voltage VDD.

The sixth power supply voltage VCOMP may provide a current to the driving transistor in the case that the threshold voltage of the driving transistor is compensated for.

FIG. 1 shows a structure in which all the first, second, third, fourth, fifth, and sixth power supply voltages VDD, VSS, VREF, VINT1, VINT2, and VCOMP may be provided from the power supply part PWS, however, the disclosure should not be limited thereto or thereby. As an example, both of the first power supply voltage VDD and the second power supply voltage VSS may be provided regardless of the structure of the pixel PXij, however, at least one of the third power supply voltage VREF, the fourth power supply voltage VINT1, the fifth power supply voltage VINT2, and the sixth power supply voltage VCOMP may not be provided according to the structure of the pixel PXij.

According to the disclosure, signal lines electrically connected to the pixel PXij may be designed in various ways by taking into account the circuit structure of the pixel PXij.

The scan driver SDC may receive a first control signal SCS from the timing controller TC and may provide a scan signal to each of the first scan lines GWL1 to GWLn, the second scan lines GCL1 to GCLn, the third scan lines GIL1 to GILn, the fourth scan lines GBL1 to GBLn, and the fifth scan lines GRL1 to GRLn in response to the first control signal SCS.

The scan signal may be set to a voltage to allow the transistors to be turned on in response to the scan signal. As an example, the scan signal provided to a P-type transistor may be set to a logic low level, and the scan signal provided to an N-type transistor may be set to a logic high level. Hereinafter, the expression "The scan signal is provided." May mean that the scan signal may be provided to the transistor, which may be controlled thereby, with a logic level that turns on the transistor.

For the convenience of explanation, FIG. 1 shows one scan driver SDC, however, the disclosure should not be limited thereto or thereby. According to an embodiment, the display device DD may include multiple scan drivers to provide the scan signal to each of the first scan lines GWL1 to GWLn, the second scan lines GCL1 to GCLn, the third scan lines GIL1 to GILn, the fourth scan lines GBL1 to GBLn, and the fifth scan lines GRL1 to GRLn.

The emission driver EDC may provide an emission signal to the emission lines ESL1 to ESLn in response to a second control signal ECS. As an example, the emission signals may be sequentially provided to the emission lines ESL1 to ESLn.

Each transistor electrically connected to the emission lines ESL1 to ESLn may be the N-type transistor. The emission signal provided to the emission lines ESL1 to ESLn may have a gate-off voltage. The transistors may be turned off in the case that receiving the emission signal and may be turned on in other cases.

The second control signal ECS may include an emission start signal and clock signals, and the emission driver EDC may be implemented by a shift register that sequentially shifts the emission start signal with a pulse shape using the clock signals to sequentially generate and output emission signals with a pulse shape.

The data driver DDC may receive a third control signal DCS and image data RGB from the timing controller TC. The data driver DDC may convert the image data RGB in a digital form to analog data signals, i.e., data signals. The data driver DDC may provide the data signals to the data lines DL1 to DLm in response to the third control signal DCS.

The third control signal DCS may include a data enable signal, a horizontal start signal, and a data clock signal to indicate an output of a valid data signal. As an example, the data driver DDC may include a shift register that shifts the horizontal start signal in synchronization with the data clock signal to generate a sampling signal, a latch that latches the image data RGB in response to the sampling signal, a digital-to-analog converter (or a decoder) that converts the latched image data, e.g., data in the digital form, to the data signals in the analog form, and buffers (or amplifiers) that output the data signals to the data lines DL1 to DLm.

The power supply part PWS may provide the first power supply voltage VDD, the second power supply voltage VSS, the third power supply voltage VREF to the display panel DP to drive the pixel PXij. In addition, the power supply part PWS may provide at least one voltage of the fourth power supply voltage VINT1, the fifth power supply voltage VINT2, and the sixth power supply voltage VCOMP to the display panel DP.

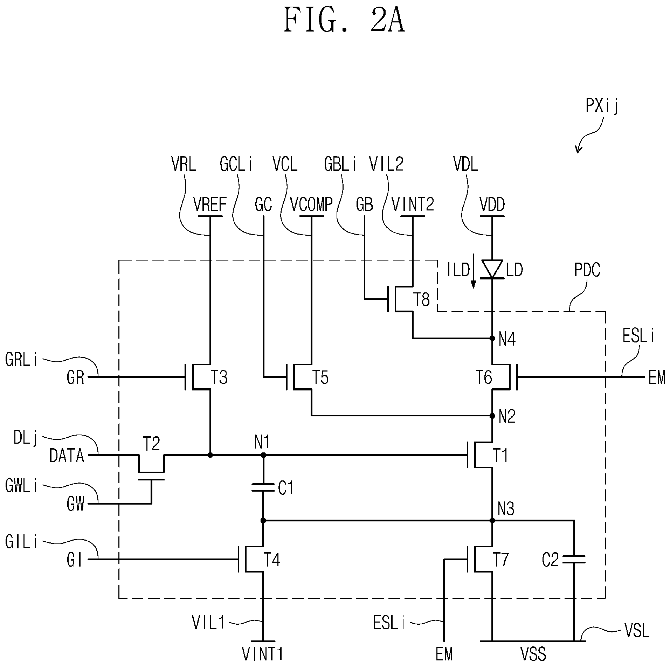

As an example, the power supply part PWS may provide the first power supply voltage VDD, the second power supply voltage VSS, the third power supply voltage VREF, the fourth power supply voltage VINT1, the fifth power supply voltage VINT2, and the sixth power supply voltage VCOMP to the display panel DP respectively via a first power line VDL (refer to FIG. 2A), a second power line VSL (refer to FIG. 2A), a third power line (or a reference voltage line, refer to FIG. 2A) VRL, a fourth power line (or a first initialization voltage line, refer to FIG. 2A) VIL1, a fifth power line (or a second initialization voltage line, refer to FIG. 2A) VIL2, and a sixth power line (or a compensation voltage line, refer to FIG. 2A) VCL, which are shown in FIG. 2A.

The power supply part PWS may be implemented by a power management integrated circuit, however, the disclosure should not be limited thereto or thereby.

The timing controller TC may generate the first control signal SCS, the second control signal ECS, the third control signal DCS, and a fourth control signal PCS based on input image data IRGB, a synchronization signal Sync, e.g., a vertical synchronization signal, a horizontal synchronization signal, etc., a data enable signal DE, and a clock signal. The first control signal SCS may be applied to the scan driver SDC, the second control signal ECS may be applied to the emission driver EDC, the third control signal DCS may be applied to the data driver DDC, and the fourth control signal PCS may be applied to the power supply part PWS. The timing controller TC may rearrange the input image data IRGB to correspond to an arrangement of the pixels in the display panel DP and may generate the image data RGB (or frame data).

The scan driver SDC, the emission driver EDC, the data driver DDC, the power supply part PWS, and/or the timing controller TC may be formed (e.g., directly formed) in the display panel DP or may be electrically connected to the display panel DP after being implemented in a separate driving chip. In addition, at least two of the scan driver SDC, the emission driver EDC, the data driver DDC, the power supply part PWS, and the timing controller TC may be implemented in a single driving chip. As an example, the data driver DDC and the timing controller TC may be provided in a single driving chip.

Details of the display device DD may be described with reference to FIG. 1, however, the display device DD should not be limited thereto or thereby. Signal lines may be added or omitted depending on the structure of the pixels. In addition, a connection relationship between one pixel and the signal lines may be changed. In a case where one of the signal lines may be omitted, the omitted signal line may be replaced with another signal line.

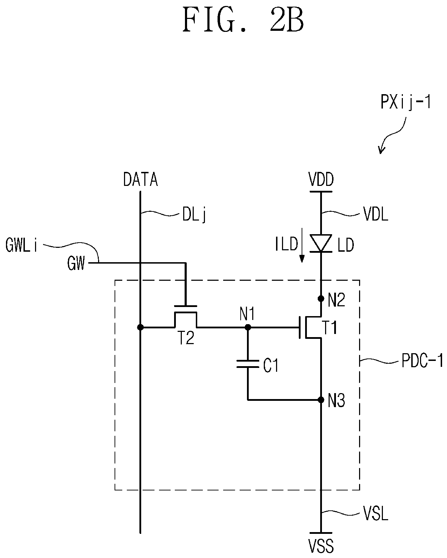

FIGS. 2A and 2B are schematic diagrams of equivalent circuits of pixels PXij and PXij-1 according to embodiments of the disclosure. FIGS. 2A and 2B show the equivalent circuit diagrams of the pixels PXij and PXij-1, which may be electrically connected to the i-th first scan line GWLi and the j-th data line (hereinafter, referred to as a data line) DLj.

Referring to FIG. 2A, the pixel PXij may include a light emitting device LD and a pixel driver PDC. The light emitting device LD may be electrically connected to the first power line VDL and the pixel driver PDC.

The pixel driver PDC may be electrically connected to the scan lines GWLi, GCLi, GILi, GBLi, and GRLi, the data line DLj, the emission line ESLi, and the power lines VDL, VSL, VIL1, VIL2, VRL, and VCL (hereinafter, some of the power lines will be referred to as power lines and the other will be referred to as voltage lines). The pixel driver PDC may include first, second, third, fourth, fifth, sixth, seventh, and eighth transistors T1, T2, T3, T4, T5, T6, T7, and T8, a first capacitor C1, and a second capacitor C2. Hereinafter, each of the first, second, third, fourth, fifth, sixth, seventh, and eighth transistors T1, T2, T3, T4, T5, T6, T7, and T8 will be described as the N-type transistor, however, the disclosure should not be limited thereto or thereby. According to an embodiment, some of the first to eighth transistors T1 to T8 may be the N-type transistor, and the other of the first to eighth transistors T1 to T8 may be the P-type transistor, or each of the first to eighth transistors T1 to T8 may be the P-type transistor, and the disclosure should not be particularly limited.

A gate of the first transistor T1 may be electrically connected to a first node N1. A first electrode of the first transistor T1 may be electrically connected to a second node N2, and a second electrode of the first transistor T1 may be electrically connected to a third node N3. The first transistor T1 may be a driving transistor. The first transistor T1 may control a driving current ILD flowing from the first power line VDL to the second power line VSL via the light emitting device LD in response to a voltage of the first node N1. The first power supply voltage VDD may be set to a voltage with an electric potential higher than the second power supply voltage VSS.

In the disclosure, the expression "A transistor is electrically connected to a signal line or another transistor." May mean that a source, drain, or gate of the transistor and the signal line are integral with each other or the source, drain or gate of the transistor is electrically connected to the signal line or other transistor via a connection electrode.

The second transistor T2 may include a gate electrically connected to the write scan line GWLi, a first electrode electrically connected to the data line DLj, and a second electrode electrically connected to the first node N1. The second transistor T2 may provide the data signal DATA to the first node N1 in response to a write scan signal GW applied thereto via the write scan line GWLi. The second transistor T2 may be turned on in the case that the write scan signal GW is applied to the write scan line GWLi, and thus, the data line DLj may be electrically connected to the first node N1.

The third transistor T3 may be electrically connected between the first node N1 and the reference voltage line VRL. A first electrode of the third transistor T3 may receive the reference voltage VREF via the reference voltage line VRL, and a second electrode of the third transistor T3 may be electrically connected to the first node N1. In the embodiment, a gate of the third transistor T3 may receive a reset scan signal GR via the i-th fifth scan line (hereinafter, referred to as the reset scan line) GRLi. The third transistor T3 may be turned on in the case that the reset scan signal GR is applied to the reset scan line GRLi and may provide the reference voltage VREF to the first node N1.

The fourth transistor T4 may be electrically connected between the third node N3 and the first initialization voltage line VIL1. A first electrode of the fourth transistor T4 may be electrically connected to the third node N3, and a second electrode of the fourth transistor T4 may be electrically connected to the first initialization voltage line VIL1 through which the first initialization voltage VINT1 may be provided. The fourth transistor T4 may be referred to as a first initialization transistor. A gate of the fourth transistor T4 may receive a first initialization scan signal GI via the i-th third scan line (hereinafter, referred to as the first initialization scan line) GILi. The fourth transistor T4 may be turned on in the case that the first initialization scan signal GI is provided to the first initialization scan line GILi and may provide the first initialization voltage VINT1 to the third node N3.

The fifth transistor T5 may be electrically connected between the compensation voltage line VCL and the second node N2. A first electrode of the fifth transistor T5 may receive the compensation voltage VCOMP via the compensation voltage line VCL, and a second electrode of the fifth transistor T5 may be electrically connected to the second node N2 to be electrically connected to the first electrode of the first transistor T1. A gate of the fifth transistor T5 may receive a compensation scan signal GC via the i-th second scan line (hereinafter, referred to as the compensation scan line) GCLi. The fifth transistor T5 may be turned on in the case that the compensation scan signal GC is provided to the compensation scan line GCLi and may provide the compensation voltage VCOMP to the second node N2, and thus, the threshold voltage of the first transistor T1 may be compensated for during a compensation period.

The sixth transistor T6 may be electrically connected between the first transistor T1 and the light emitting device LD. In detail, a gate of the sixth transistor T6 may receive the emission signal EM via the i-th emission line (hereinafter, referred to as an emission line) ESLi. A first electrode of the sixth transistor T6 may be electrically connected to the cathode of the light emitting device LD via a fourth node N4, and a second electrode of the sixth transistor T6 may be electrically connected to the first electrode of the first transistor T1 via the second node N2. The sixth transistor T6 may be referred to as a first emission control transistor. The sixth transistor T6 may be turned on in the case that the emission signal EM is provided to the emission line ESLi, and thus, the light emitting device LD may be electrically connected to the first transistor T1.

The seventh transistor T7 may be electrically connected between the second power line VSL and the third node N3. A first electrode of the seventh transistor T7 may be electrically connected to the second electrode of the first transistor T1 via the third node N3, and a second electrode of the seventh transistor T7 may receive the second power supply voltage VSS via the second power line VSL. A gate of the seventh transistor T7 may be electrically connected to the emission line ESLi. The seventh transistor T7 may be referred to as a second emission control transistor. The seventh transistor T7 may be turned on in the case that the emission signal EM may be provided to the emission line ESLi, and thus, the second electrode of the first transistor T1 may be electrically connected to the second power line VSL.

According to the embodiment, the sixth transistor T6 and the seventh transistor T7 may be electrically connected to the same emission line ESLi and may be turned on in response to the same emission signal EM, however, this may be merely an example. According to an embodiment, the sixth transistor T6 and the seventh transistor T7 may be independently turned on in response to different signals distinguished from each other. In addition, according to an embodiment, one of the sixth transistor T6 and the seventh transistor T7 may be omitted from the pixel driver PDC.

The eighth transistor T8 may be electrically connected between the second initialization voltage line VIL2 and the fourth node N4. For example, the eighth transistor T8 may include a gate electrically connected to the i-th fourth scan line (hereinafter, referred to as the second initialization scan line) GBLi, a first electrode electrically connected to the second initialization voltage line VIL2, and a second electrode electrically connected to the fourth node N4. The eighth transistor T8 may be referred to as a second initialization transistor. The eighth transistor T8 may provide the second initialization voltage VINT2 to the fourth node N4 corresponding to the cathode of the light emitting device LD in response to a second initialization scan signal GB applied thereto via the second initialization scan line GBLi. The cathode of the light emitting device LD may be initialized by the second initialization voltage VINT2.

According to the embodiment, some of the second, third, fourth, fifth, sixth, seventh, and eighth transistors T2, T3, T4, T5, T6, T7, and T8 may be substantially simultaneously turned on in response to the same scan signal. As an example, the eighth transistor T8 and the fifth transistor T5 may be substantially simultaneously turned on in response to the same scan signal. As an example, the eighth transistor T8 and the fifth transistor T5 may be operated in response to the same compensation scan signal GC. The eighth transistor T8 and the fifth transistor T5 may be substantially simultaneously turned on and off in response to the same compensation scan signal GC. The compensation scan line GCLi and the second initialization scan line GBLi may be substantially provided as a single scan line. Accordingly, the initialization of the cathode of the light emitting device LD and the compensation of the threshold voltage of the first transistor T1 may be performed at the same timing, however, the disclosure should not be limited thereto or thereby.

According to the disclosure, the initialization of the cathode of the light emitting device LD and the compensation of the threshold voltage of the first transistor T1 may be performed in response to the same power voltage. As an example, the compensation voltage line VCL and the second initialization voltage line VIL2 may be substantially provided as a single power line. The initialization operation of the cathode and the compensation operation of the driving transistor may be performed using one power voltage, and thus, a design for the drivers may be simplified. However, this may be merely an example, and the disclosure should not be particularly limited.

The first capacitor C1 may be disposed between the first node N1 and the third node N3. The first capacitor C1 may be charged with a voltage corresponding to a difference between the voltage of the first node N1 and the voltage of the third node N3. The first capacitor C1 may be referred to as a storage capacitor.

The second capacitor C2 may be disposed between the third node N3 and the second power line VSL. For example, an electrode of the second capacitor C2 may be electrically connected to the second power line VSL receiving the second power supply voltage VSS, and another electrode of the second capacitor C2 may be electrically connected to the third node N3. The second capacitor C2 may be charged with electric charges corresponding to a difference in voltage between the second power supply voltage VSS and the third node N3. The second capacitor C2 may be referred to as a hold capacitor. The second capacitor C2 may have a higher storage capacity compared with the first capacitor C1. Accordingly, the second capacitor C2 may reduce a variation in voltage of the third node N3 according to a variation in voltage of the first node N1.

In the embodiment, the light emitting device LD may be electrically connected to the pixel driver PDC via the fourth node N4. The light emitting device LD may include an anode electrically connected to the first power line VDL and the cathode opposite to the anode. In the embodiment, the light emitting device LD may be electrically connected to the pixel driver PDC through the cathode thereof. For example, according to the pixel PXij, a connection node at which the light emitting device LD may be electrically connected to the pixel driver PDC may be the fourth node N4, and the fourth node N4 may correspond to a connection node between the first electrode of the sixth transistor T6 and the cathode of the light emitting device LD. Accordingly, an electric potential of the fourth node N4 may correspond to an electric potential of the cathode of the light emitting device LD.

In detail, the anode of the light emitting device LD may be electrically connected to the first power line VDL, the first power supply voltage VDD that may be a constant voltage may be applied to the anode, and the cathode may be electrically connected to the first transistor T1 via the sixth transistor T6. For example, an electric potential of the third node N3 corresponding to a source of the first transistor T1, which may be the driving transistor, may not be affected (e.g., directly affected) by characteristics of the light emitting device LD in the embodiment where each of the first to eighth transistors T1 to T8 is the N-type transistor. Accordingly, even though the light emitting device LD may be deteriorated, an influence of the deterioration in the characteristics of the light emitting device LD on a gate-source voltage (Vgs) of the transistors constituting the pixel driver PDC, especially the driving transistor, may be reduced. For example, since a range of change in an amount of the driving current ILD due to the deterioration of the light emitting device LD may be reduced, an image retention defect of the display panel according to the increase in usage time may be reduced, and a lifespan of the display panel may be improved.

As shown in FIG. 2B, the pixel PXij-1 may include a pixel driver PDC-1 including two transistors T1 and T2 and one capacitor C1. The pixel driver PDC-1 may be electrically connected to a light emitting device LD, a write scan line GWLi, a data line DLj, and a second power line VSL. The pixel driver PDC-1 shown in FIG. 2B may have a circuit configuration obtained by removing the third to eighth transistors T3 to T8 and the second capacitor C2 from the pixel driver PDC shown in FIG. 2A.

Each of the first and second transistors T1 and T2 may be an N-type transistor or a P-type transistor. In the embodiment, each of the first and second transistors T1 and T2 will be described as the N-type transistor.

The first transistor T1 may include a gate electrically connected to a first node N1, a first electrode electrically connected to a second node N2, and a second electrode electrically connected to a third node N3. The second node N2 may be electrically connected to a first power line VDL, and the third node N3 may be electrically connected to the second power line VSL. The first transistor T1 may be electrically connected to the light emitting device LD via the second node N2 and may be electrically connected to the second power line VSL via the third node N3. The first transistor T1 may be a driving transistor.

The second transistor T2 may include a gate receiving a write scan signal GW via the write scan line GWLi, a first electrode electrically connected to the data line DLj, and a second electrode electrically connected to the first node N1. The second transistor T2 may provide a data signal DATA to the first node N1 in response to the write scan signal GW applied thereto via the write scan line GWLi.

The capacitor C1 may include an electrode electrically connected to the first node N1 and an electrode electrically connected to the third node N3. The capacitor C1 may be charged with the data signal DATA applied to the first node N1.

The light emitting device LD may include an anode and a cathode. In the embodiment, the anode of the light emitting device LD may be electrically connected to the first power line VDL, and the cathode of the light emitting device LD may be electrically connected to the pixel driver PDC-1 via the second node N2. In the embodiment, the cathode of the light emitting device LD may be electrically connected to the first transistor T1. The light emitting device LD may emit light in response to an amount of current flowing through the first transistor T1 of the pixel driver PDC-1.

The second node N2 at which the cathode of the light emitting device LD may be electrically connected to the pixel driver PDC-1 may correspond to a drain of the first transistor T1 in the embodiment where each of the first and second transistors T1 and T2 may be the N-type transistor. For example, the display panel may prevent a variation in a gate-source voltage (Vgs) of the first transistor T1, which may be caused by the light emitting device LD. Accordingly, a range of change in an amount of the driving current ILD due to deterioration of the light emitting device LD may be reduced, the image retention defect of the display panel according to the increase in usage time may be reduced, and the lifespan of the display panel may be improved.

FIGS. 2A and 2B show the circuit configurations of the pixel drivers PDC and PDC-1 according to embodiments of the disclosure. In the display panel according to the embodiments of the disclosure, the number and arrangement of the transistors and the number and arrangement of the capacitors may be designed in various ways and should not be particularly limited as long as the circuit of the pixel driver is electrically connected to the cathode of the light emitting device LD.

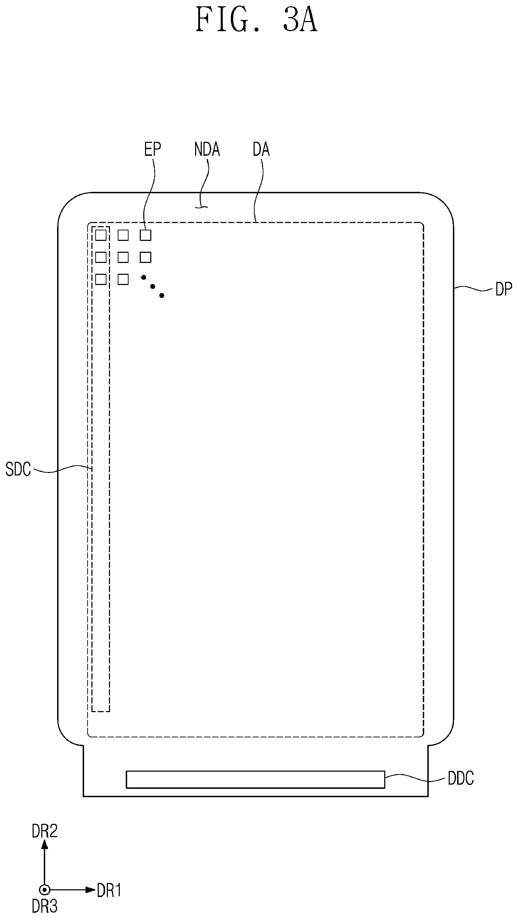

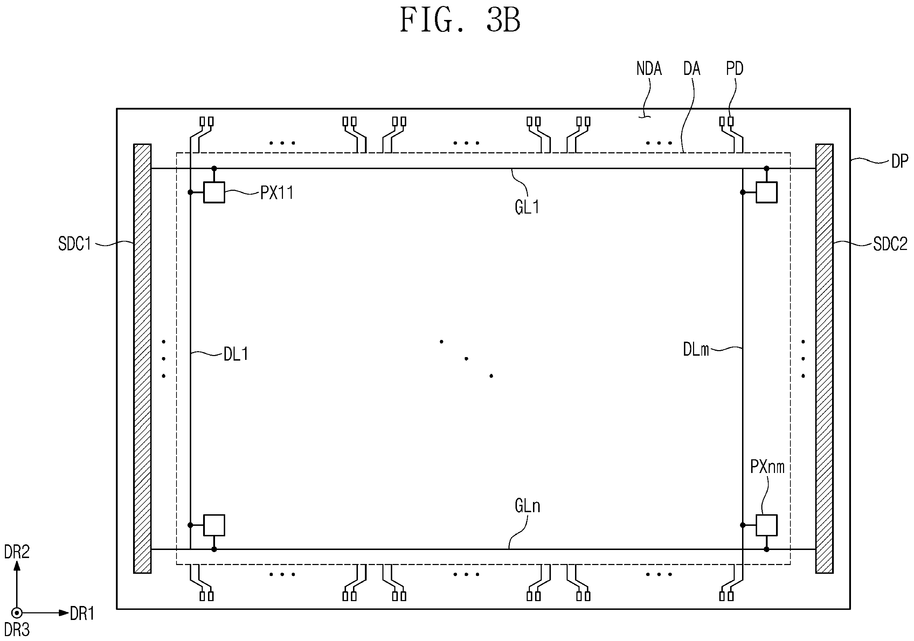

FIGS. 3A and 3B are plan views of display panels according to embodiments of the disclosure. In FIGS. 3A and 3B, some components may be omitted. Hereinafter, the disclosure will be described with reference to FIGS. 3A and 3B. Referring to FIG. 3A, the display panel DP may include a display area DA and a peripheral area (or a non-display area) NDA. The display area DA may include multiple light emitting parts EP.

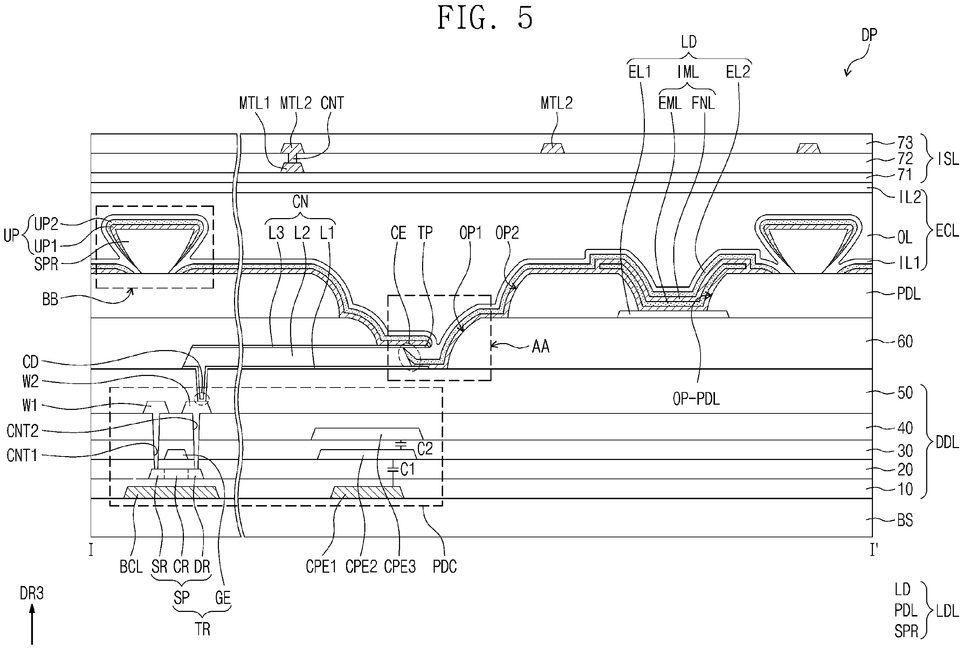

The light emitting parts EP may be areas where the pixels emit the light. In detail, each of the light emitting parts EP may correspond to a light emitting opening OP-PDL (refer to FIG. 5) described later.

The peripheral area NDA may be defined adjacent to the display area DA. In the embodiment, the peripheral area NDA may have a shape surrounding an edge of the display area DA, however, this may be merely an example. According to an embodiment, the peripheral area NDA may be defined adjacent to one side of the display area DA or may be omitted, and it should not be particularly limited.

In the embodiment, the scan driver SDC and the data driver DDC may be mounted on the display panel DP. The scan driver SDC may be disposed in the display area DA, and the data driver DDC may be disposed in the peripheral area NDA. The scan driver SDC may overlap at least some of the light emitting parts EP arranged in the display area DA in a plan view. As the scan driver SDC may be disposed in the display area DA, a size of the peripheral area NDA may be reduced compared with that of a conventional display panel in which a scan driver is disposed in a peripheral area, and thus, a narrow bezel of the display device DD (refer to FIG. 1) may be readily implemented.

Different from the scan driver SDC shown in FIG. 3A, the scan driver SDC may be provided in two parts distinguished from each other. The two scan drivers SDC may be respectively disposed at left and right sides of the display area DA and may be spaced apart from each other with a center of the display area DA disposed therebetween. According to an embodiment, three or more scan drivers SDC may be employed, and the number of the scan drivers SDC should not be particularly limited.

FIG. 3A shows a representative example of the display panel, however, according to an example, the data driver DDC may be disposed in the display area DA. In the case that the data driver DDC may be disposed in the display area DA, some of the light emitting parts EP arranged in the display area DA may overlap the data driver DDC in a plan view.

The data driver DDC may be provided in a separate driving chip independently formed from the display panel DP and may be electrically connected to the display panel DP, however, this may be merely an example. According to an embodiment, the data driver DDC may be formed through the same process as the scan driver SDC in the case that the display panel DP may be manufactured, and it should not be limited thereto or thereby.

Referring to FIG. 3B, the display panel DP may have a shape in which a length in a first direction DR1 may be longer than a length in a second direction DR2. The pixels PX11 to PXnm may be arranged in n rows by m columns in the display area DA. In the embodiment, the display panel DP may include multiple scan drivers SDC1 and SDC2. The scan drivers SDC1 and SDC2 may include a first scan driver SDC1 and a second scan driver SDC2, which may be spaced apart from each other in the first direction DR1.

In FIG. 3B, the first scan driver SDC1 may be electrically connected to scan lines GL1 to GLn, and the second scan driver SDC2 may be electrically connected to the scan lines GL1 to GLn. Alternatively, the first scan driver SDC1 may be electrically connected to some scan lines of scan lines GL1 to GLn, and the second scan driver SDC2 may be electrically connected to the other scan lines among the scan lines GL1 to GLn. As an example, the first scan driver SDC1 may be electrically connected to odd-numbered scan lines among the scan lines GL1 to GLn, and the second scan driver SDC2 may be electrically connected to even-numbered scan lines among the scan lines GL1 to GLn.

For the convenience of explanation, FIG. 3B shows pads PD of data lines DL1 to DLm. The pads PD may be placed at ends of the data lines DL1 to DLm. The data lines DL1 to DLm may be electrically connected to the data driver DDC (refer to FIG. 3A) via the pads PD.

According to the disclosure, the pads PD may be arranged in areas of the peripheral area NDA, which may be spaced apart from each other with the display area DA disposed therebetween. As an example, some pads among the pads PD may be arranged in an upper portion of the display panel DP, which may be adjacent to a first scan line GL1 among the scan lines GL1 to GLn, and the other pads among the pads PD may be arranged in a lower portion of the display panel DP, which may be adjacent to the last scan line GLn among the scan lines GL1 to GLn. In the embodiment, pads that are electrically connected to odd-numbered data lines may be arranged in the upper portion, and pads that are electrically connected to even-numbered data lines may be arranged in the lower portion.

Although not shown in figures, the display panel DP may include upper data drivers electrically connected to the pads PD arranged in the upper portion and lower data drivers electrically connected to the pads PD arranged in the lower portion, however, these may be merely examples. According to an embodiment, the display panel DP may include one upper data driver electrically connected to the pads PD arranged in the upper portion and/or one lower data driver electrically connected to the pads PD arranged in the lower portion. According to an embodiment, the pads PD may be arranged in one side portion and may be electrically connected to a single data driver, however, the disclosure should not be particularly limited.

As described with reference to FIG. 3A, the display panel DP shown in FIG. 3B may include the scan driver and/or the data driver arranged in the display area DA, and thus, some of the light emitting parts arranged in the display area DA may overlap the scan driver and/or the data driver in a plan view.

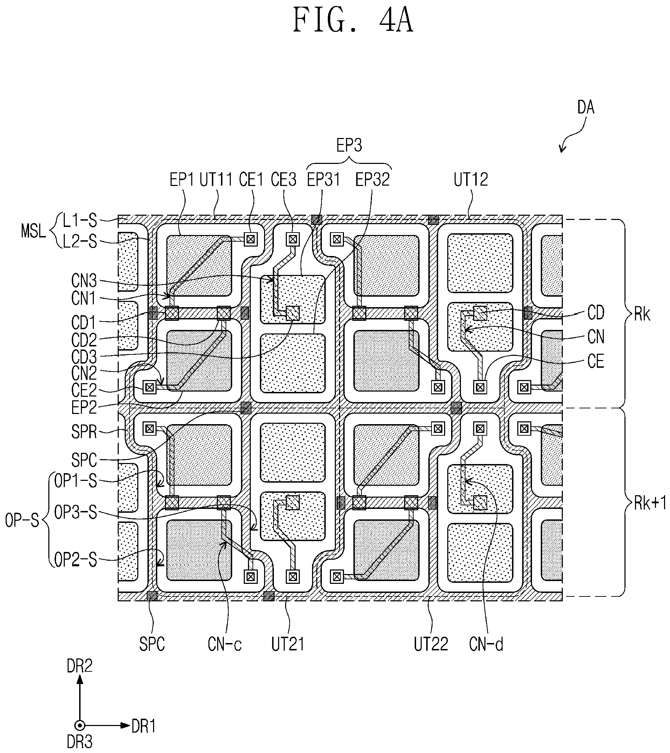

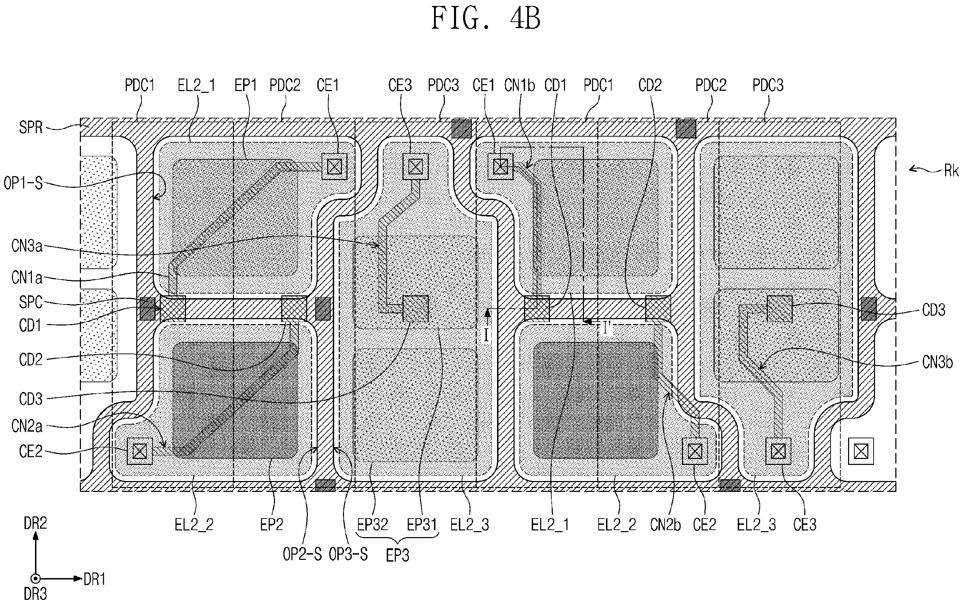

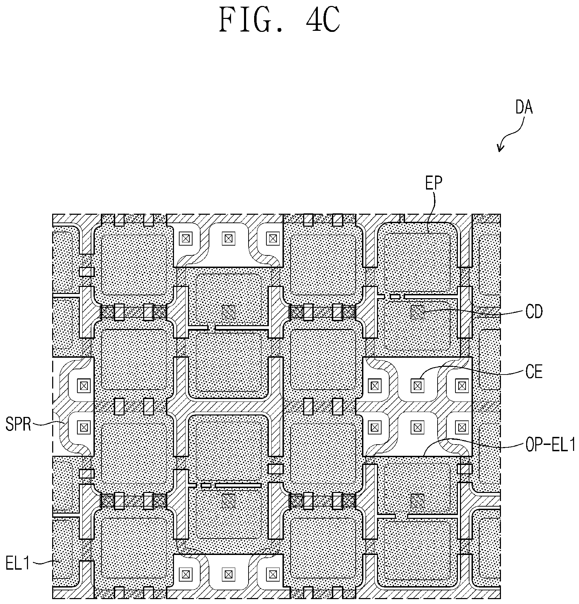

FIGS. 4A to 4C are enlarged plan views of some areas of a display panel according to an embodiment of the disclosure. FIG. 4A shows an area in which four light emitting units may be arranged in two rows by two columns, and FIG. 4B may be an enlarged view of an area shown in FIG. 4A. FIG. 4C shows the area of the display panel of FIG 4A, however, for the convenience of explanation, some components may be emphasized or may not be illustrated. Hereinafter, the disclosure will be described with reference to FIGS. 4A to 4C.

FIG. 4A shows the light emitting units UT11, UT12, UT21, and UT22 arranged in two rows by two columns. Light emitting parts arranged in a first row Rk may include light emitting parts constituting the light emitting unit UT11 arranged in a first row and a first column and the light emitting unit UT12 arranged in the first row and a second column, and light emitting parts arranged in a second row Rk+1 may include light emitting parts constituting the light emitting unit UT21 arranged in a second row and the first column and the light emitting unit UT22 arranged in the second row and the second column. FIG. 4B shows the light emitting parts arranged in the first row Rk. FIGS. 4A to 4C show a separator SPR, multiple light emitting parts EP1, EP2, and EP3 disposed in areas divided by the separator SPR, connection wirings CN1, CN2, and CN3, a first electrode EL1, second electrodes EL2_1, EL2_2, and EL2_3, and a spacer SPC.

As described above, each of the light emitting parts EP1, EP2, and EP3 may correspond to a light emitting opening OP-PDL (refer to FIG. 5) described later. For example, each of the light emitting parts EP1, EP2, and EP3 may be an area from which the light may be emitted by the light emitting device described above and may correspond to a part providing the image displayed through the display panel DP (refer to FIG. 1). In more detail, each of the light emitting parts EP1, EP2, and EP3 may correspond to an area defined by the light emitting opening OP-PDL (refer to FIG. 5).

The light emitting parts EP1, EP2, and EP3 may include a first light emitting part EP1, a second light emitting part EP2, and a third light emitting part EP3. The first light emitting part EP1, the second light emitting part EP2, and the third light emitting part EP3 may emit light having different colors from each other. As an example, the first light emitting part EP1 may emit a red light, the second light emitting part EP2 may emit a green light, and the third light emitting part EP3 may emit a blue light, however, colors of the first, second, and third light emitting parts EP1, EP2, and EP3 should not be limited thereto or thereby. In addition, at least two of the light emitting parts EP1, EP2, and EP3 may emit the light having the same color. For instance, all the first, second, and third light emitting parts EP1, EP2, and EP3 may emit a blue light or a white light.

Among the light emitting parts EP1, EP2, and EP3, the third light emitting part EP3 that displays the light emitted by a third light emitting device may include two sub-light emitting parts EP31 and EP32 spaced apart from each other in the second direction DR2, however, this is merely an example. According to an embodiment, the third light emitting part EP3 may be provided in a single pattern having an integral shape like the other light emitting parts EP1 and EP2, or at least one of the other light emitting parts EP1 and EP2 may include sub-light emitting parts spaced apart from each other, and the disclosure should not be particularly limited.

The light emitting parts arranged in the first row Rk may include light emitting parts EP1, EP2, and EP3 constituting the light emitting unit UT11 arranged in the first row and the first column and the light emitting unit UT12 arranged in the first row and the second column, and the light emitting parts arranged in the second row Rk+1 may include light emitting parts EP1, EP2, and EP3 constituting the light emitting unit UT21 arranged in the second row and the first column and the light emitting unit UT22 arranged in the second row and the second column. A portion of the light emitting parts arranged in the first row Rk and a portion of the light emitting parts arranged in the second row Rk+1 may be symmetrical with each other. As an example, the first and second light emitting parts EP1 and EP2 of the light emitting unit UT12 arranged in the first row and the second column and the first and second light emitting parts EP1 and EP2 of the light emitting unit UT11 arranged in the first row and the first column have a shape and arrangement that may be line-symmetric about an axis parallel to the second direction DR2. The third light emitting part EP3 of the light emitting unit UT21 arranged in the second row and the first column may have a shape and arrangement that may be line-symmetric about an axis parallel to the first direction DR1 with respect to the third light emitting part EP3 of the light emitting unit UT11 arranged in the first row and the first column.

Hereinafter, the light emitting unit UT11 arranged in the first row and the first column will be described in detail. For the convenience of explanation, FIG. 4B shows the second electrodes EL2_1, EL2_2, and EL2_3, pixel drivers PDC1, PDC2, and PDC3, and connection wirings CN1a, CN1b, CN2a, CN2b, CN3a, and CN3b. The second electrodes EL2_1, EL2_2, and EL2_3 are separated from each other and electrically disconnected from each other by the separator SPR.

The separator SPR is provided with multiple division openings OP-S defined therethrough. The second electrodes EL2_1, EL2_2, and EL2_3 may be respectively disposed in the division openings OP-S to be separated from each other. Accordingly, the arrangement and shape of the second electrodes EL2_1, EL2_2, and EL2_3 may correspond to the arrangement and shape of the division openings OP-S of the separator SPR.

In the embodiment, the separator SPR may include division mesh lines MSL, and the division mesh lines MSL may include first lines L1-S extending in the first direction DR1 and second lines L2-S extending in the second direction DR2. The division openings OP-S of the separator SPR may be defined by the division mesh lines MSL.

In the embodiment, one light emitting unit may include three light emitting parts EP1, EP2, and EP3. Accordingly, one light emitting unit may include three second electrodes EL2_1, EL2_2, and EL2_3 (hereinafter, referred to as first, second, and third cathodes), three pixel drivers PDC1, PDC2, and PDC3, and three connection wirings CN1a, CN2a, and CN3a or CN1b, CN2b, and CN3b, however, this may be merely an example. According to an embodiment, the number and arrangement of the light emitting units may be designed in various ways and should not be particularly limited.

First, second, and third division openings OP1-S, OP2-S, and OP3-S may be defined through the separator SPR. The first, second, and third division openings OP1-S, OP2-S, and OP3-S may respectively overlap the first, second, and third light emitting parts EP1, EP2, and EP3. In a plan view (or when viewed from a top side of the display device), the first, second, and third division openings OP1-S, OP2-S, and OP3-S may respectively surround the first, second, and third light emitting parts EP1, EP2, and EP3. In a plan view, the first, second, and third light emitting parts EP1, EP2, and EP3 may be disposed in the first, second, and third division openings OP1-S, OP2-S, and OP3-S, respectively. The first, second, and third cathodes EL2_1, EL2_2, and EL2_3 may be separated from each other by the separator SPR and may be disposed in the first, second, and third division openings OP1-S, OP2-S, and OP3-S, respectively.

First, second, and third pixel drivers PDC1, PDC2, and PDC3 may be electrically connected to the light emitting devices forming the first, second, and third light emitting parts EP1, EP2, and EP3, respectively. In the disclosure, the expression that a component A may be electrically connected to a component B may mean not only a case where the component A may be connected (e.g., directly and physically connected) to the component B, but also a case where the component A may be electrically connected to the component B.

As shown in FIG. 4B, each area where the pixel drivers PDC1, PDC2, and PDC3 may be defined on a plane may correspond to a part in which transistors and capacitors constituting the pixel driver (or circuit) PDC (refer to FIG. 2A) that drives the light emitting device of the pixel may be repeatedly arranged.

The first, second, and third pixel drivers PDC1, PDC2, and PDC3 may be sequentially arranged in the first direction DR1. The arrangement positions of the first, second, and third pixel drivers PDC1, PDC2, and PDC3 may be independently designed regardless of positions or shapes of the first, second, and third light emitting parts EP1, EP2, and EP3.

As an example, the first, second, and third pixel drivers PDC1, PDC2, and PDC3 may be placed at positions different from the areas divided by the separator SPR (i.e., positions at which the first, second, and third cathodes EL2_1, EL2_2, and EL2_3 may be placed or may be designed to have shapes and sizes different from the shapes and sizes of the first, second, and third cathodes EL2_1, EL2_2, and EL2_3). According to an embodiment, the first, second, and third pixel drivers PDC1, PDC2, and PDC3 may be placed to respectively overlap the positions at which the first, second, and third light emitting parts EP1, EP2, and EP3 may be placed and may be designed to have shapes and sizes similar to those of the areas divided by the separator SPR (i.e., shapes and sizes of the first, second, and third cathodes EL2_1, EL2_2, and EL2_3).

In the embodiment, each of the first, second, and third pixel drivers PDC1, PDC2, and PDC3 may have a rectangular shape, each of the first, second, and third light emitting parts EP1, EP2, and EP3 may have a size smaller than and a shape different from those of the first, second, and third pixel drivers PDC1, PDC2, and PDC3, and the first, second, and third cathodes EL2_1, EL2_2, and EL2_3 may be placed at positions overlapping the first, second, and third light emitting parts EP1, EP2, and EP3 and may have an atypical shape.

Accordingly, as shown in FIG. 4B, the first pixel driver PDC1 may be placed at a position overlapping the first light emitting part EP1, the second light emitting part EP2, and a portion of another light emitting part adjacent thereto. The second pixel driver PDC2 may be placed at a position overlapping the first light emitting part EP1, the second light emitting part EP2, and the third light emitting part EP3. The third pixel driver PDC3 may be placed at a position overlapping the third light emitting part EP3, however, these may be merely examples. According to an embodiment, the positions of the first, second, and third pixel drivers PDC1, PDC2, and PDC3 may be designed to have various shapes and arrangements independently of the light emitting parts EP1, EP2, and EP3 and should not be particularly limited.

A connection wiring CN may be provided in plural, and the connection wirings CN may be arranged spaced apart from each other. One connection wiring CN may electrically connect one pixel driver among the pixel drivers PDC1, PDC2, and PDC3 and the light emitting device corresponding thereto. In detail, the connection wiring CN may correspond to the node (refer to the fourth node N4 of FIG. 2A or the second node N2 of FIG. 2B) at which the light emitting device LD (refer to FIG. 2A) may be electrically connected to the pixel driver PDC of FIG. 2A or PDC-1 of FIG. 2B.

The connection wiring CN may include a first connection portion (or a light emitting connection part) CE and a second connection portion (or a driver connection part) CD. The light emitting connection part CE may be provided at one side of the connection wiring CN, and the driver connection part CD may be provided at the other side of the connection wiring CN.

The driver connection part CD may be a portion of the connection wiring CN, which may be electrically connected to the pixel driver PDC. In the embodiment, the driver connection part CD may be electrically connected to one electrode of a transistor forming the pixel driver PDC. In detail, the driver connection part CD may be electrically connected to the drain of the sixth transistor T6 shown in FIG. 2A or the drain of the first transistor T1 shown in FIG. 2B. Accordingly, a position of the driver connection part CD may correspond to a position of a transistor (refer to a transistor TR of FIG. 5) of the pixel driver PDC, which may be physically connected to the connection wiring CN. The light emitting connection part CE may be a portion of the connection wiring CN, which may be electrically connected to the light emitting device LD. In the embodiment, the light emitting connection part CE may be electrically connected to a second electrode EL2 (hereinafter, referred to as a cathode, refer to FIG. 5) of the light emitting device.

The light emitting part may include first, second, and third connection wirings CN1, CN2, and CN3. The first connection wiring CN1 may connect the light emitting device, which forms the first light emitting part EP1, to the first pixel driver PDC1, the second connection wiring CN2 may connect the light emitting device, which forms the second light emitting part EP2, to the second pixel driver PDC2, and the third connection wiring CN3 may connect the light emitting device, which forms the third light emitting part EP3, to the third pixel driver PDC3.

In detail, the first, second, and third connection wirings CN1, CN2, and CN3 may connect the first, second, and third cathodes EL2_1, EL2_2, and EL2_3 to the first, second, and third pixel drivers PDC1, PDC2, and PDC3, respectively. The first connection wiring CN1 may include a first driver connection part CD1 electrically connected to the first pixel driver PDC1 and a first light emitting connection part CE1 electrically connected to the first cathode EL2_1. The second connection wiring CN2 may include a second driver connection part CD2 electrically connected to the second pixel driver PDC2 and a second light emitting connection part CE2 electrically connected to the second cathode EL2_2. The third connection wiring CN3 may include a third driver connection part CD3 electrically connected to the third pixel driver PDC3 and a third light emitting connection part CE3 electrically connected to the third cathode EL2_3.

The first, second, and third driver connection parts CD1, CD2, and CD3 may be arranged in the first direction DR1. As described above, positions of the first, second, and third driver connection parts CD1, CD2, and CD3 may respectively correspond to positions of connection transistors forming the first, second, and third pixel drivers PDC1, PDC2, and PDC3. In one pixel, the connection transistor may include the connection node at which the pixel driver may be electrically connected to the light emitting device as its electrode. As an example, the connection transistor may correspond to the sixth transistor T6 of FIG. 2A or the first transistor T1 of FIG. 2B. The connection transistor may be provided in each pixel, and each of the connection transistors may be electrically connected to a second electrode of a corresponding light emitting device among the second electrodes EL2_1, EL2_2, and EL2_3 of the light emitting devices via a corresponding driver connection part among the driver connection parts CD1, CD2, and CD3. According to the disclosure, the shapes, positions, and arrangements of the pixel drivers of all pixels may be simplified regardless of the shape, size, or emission colors of the light emitting part.

In the embodiment, the first, second, and third light emitting connection parts CE1, CE2, and CE3 may be defined at positions that do not overlap the light emitting parts EP1, EP2, and EP3 in a plan view. Since each of the light emitting connection parts CE1, CE2, and CE3 of the connection wiring CN may be a portion that may be electrically connected to the light emitting device LD (refer to FIG. 5) and a portion where a tip part TP (refer to FIG. 5) may be defined, each of the light emitting connection parts CE1, CE2, and CE3 may be provided at a position that does not overlap the light emitting opening OP-PDL (refer to FIG. 5). For example, the light emitting connection parts CE1, CE2, and CE3 may be placed at positions spaced apart from the light emitting parts EP1, EP2, and EP3 in the cathodes EL2_1, EL2_2, and EL2_3, and the cathodes EL2_1, EL2_2, and EL2_3 may include some areas protruded from the light emitting parts EP1, EP2, and EP3 in a plan view to be electrically connected to the connection wirings CN1, CN2, and CN3 at positions where the light emitting connection parts CE1, CE2, and CE3 may be placed.

As an example, the first cathode EL2_1 may include a protruding portion protruded from the first light emitting part EP1 at the position that does not overlap the first light emitting part EP1 to be electrically connected to the first connection wiring CN1 at the position where the first light emitting connection part CE1 may be placed, and the first light emitting connection part CE1 may be provided in the protruding portion.

In the first pixel driver PDC1, the first driver connection part CD1 that may be the position at which the first connection wiring CN1 may be electrically connected to the transistor TR (refer to FIG. 5) may be defined at a position that does not overlap the first light emitting part EP1 in a plan view. According to the embodiment, as the first connection wiring CN1 may be disposed in the first light emitting part EP1, the first cathode EL2_1 may be readily electrically connected to the first pixel driver PDC1.

In the third pixel driver PDC3, the third driver connection part CD3 that may be the position at which the third connection wiring CN3 may be electrically connected to the transistor TR may be defined at a position that does not overlap the third light emitting connection part CE3 in a plan view and may be placed at a position overlapping the third light emitting part EP3. According to the embodiment, as the third cathode EL2_3 may be electrically connected to the third pixel driver PDC3 via the third connection wiring CN3, restrictions on the design of the third pixel driver PDC3 due to the position or shape of the third light emitting part EP3 may be reduced, and the degree of freedom in circuit design may be improved.

In the embodiment, the first, second, and third light emitting connection parts CE1, CE2, and CE3 may overlap the first, second, and third division openings OP1-S, OP2-S, and OP3-S of the separator SPR, respectively. Accordingly, in one light emitting part, the first division opening OP1-S may surround the first light emitting part EP1 and the first light emitting connection part CE1 in a plan view, the second division opening OP2-S may surround the second light emitting part EP2 and the second light emitting connection part CE2 in a plan view, and the third division opening OP3-S may surround the third light emitting part EP3 and the third light emitting connection part CE3 in a plan view.

Referring to FIG. 4A again, the shape and arrangement of the light emitting parts of the light emitting units UT21 and UT22 arranged in the second row Rk+1 and those of the light emitting parts of the light emitting units UT11 and UT12 arranged in the first row Rk may be line-symmetric about the axis parallel to the first direction DR1 or the second direction DR2. Due to the shape and arrangement of the light emitting parts UT11 and UT12 arranged in the first row Rk, the light emitting units UT21 and UT22 arranged in the second row Rk+1 may include the light emitting parts obtained by shifting the light emitting units UT11 and UT12 arranged in the first row Rk in the first direction DR1 and the second direction DR2. For example, the light emitting unit UT21 arranged in the second row and the first column may include the light emitting parts having the same shape as that of the light emitting parts included in the light emitting unit UT12 arranged in the first row and the second column, and the light emitting unit UT22 arranged in the second row and the second column may include the light emitting parts having the same shape as that of the light emitting parts included in the light emitting unit UT11 arranged in the first row and the first column.

Accordingly, connection wirings CN-c disposed in the light emitting unit UT21 arranged in the second row and the first column may have the same shape and arrangement as those of the connection wirings CN1b, CN2b, and CN3b disposed in the light emitting unit UT12 arranged in the first row and the second column. Similarly, connection wirings CN-d disposed in the light emitting unit UT22 arranged in the second row and the second column may have the same shape and arrangement as those of the connection wirings CN1a, CN2a, and CN3a disposed in the light emitting unit UT11 arranged in the first row and the first column.

Referring to FIG. 4C, the first electrode EL1 (hereinafter, referred to as an anode) of the light emitting device may be commonly disposed in the light emitting parts EP1, EP2, and EP3. For example, the anode EL1 may be formed as a single layer integrally formed, and thus, the anode EL1 formed as a layer may be disposed overlapping the separator SPR. According to an embodiment, the anodes EL1 may be formed in the light emitting devices respectively as independent conductive patterns spaced apart from each other, the anodes EL1 may be electrically connected to each other through a conductive layer, and thus, the anodes EL1 formed as patterns may be placed at positions that do not overlap the separator SPR.

As described above, the first power supply voltage VDD (refer to FIG. 2A) may be applied to the anode EL1, and a common voltage may be applied to all the light emitting parts. The anode EL1 may be electrically connected to the first power line VDL (refer to FIG. 2A) providing the first power supply voltage VDD in the peripheral area NDA or may be electrically connected to the first power line VDL in the display area DA, and it should not be limited thereto or thereby.

Openings OP-EL1 may be defined through the anode EL1, and the openings may penetrate through the anode EL1 formed as a layer. The openings OP-EL1 formed through the anode EL1 as a layer may be positioned not to overlap the light emitting parts EP and may be defined at positions overlapping the separator SPR. The openings OP-EL1 may facilitate a discharge of a gas generated from an organic layer disposed under the anode EL1, e.g., a sixth insulating layer 60 (refer to FIG. 5). Accordingly, the gas from the organic layer disposed under the light emitting device may be sufficiently discharged in a manufacturing process of the display panel, and thus, deterioration of the light emitting device, which may be caused by the gas generated from the organic layer, after the completion of the display panel may be prevented.

According to the disclosure, as the connection wiring may be disposed between the light emitting part and the pixel driver, the light emitting device may be stably electrically connected to the pixel driver by changing only the shape of the cathode without changing the arrangement and shape of the light emitting parts. Accordingly, the freedom in designing the arrangement of the pixel driver may be improved, and a size of the light emitting part or a resolution of the display panel may be readily increased.

According to the embodiment, the spacer SPC is disposed to overlap the separator SPR. The spacer SPC may be provided in plural, and at least a portion of each of the spacers SPC may overlap the separator SPR. The spacer SPC will be described in detail later.

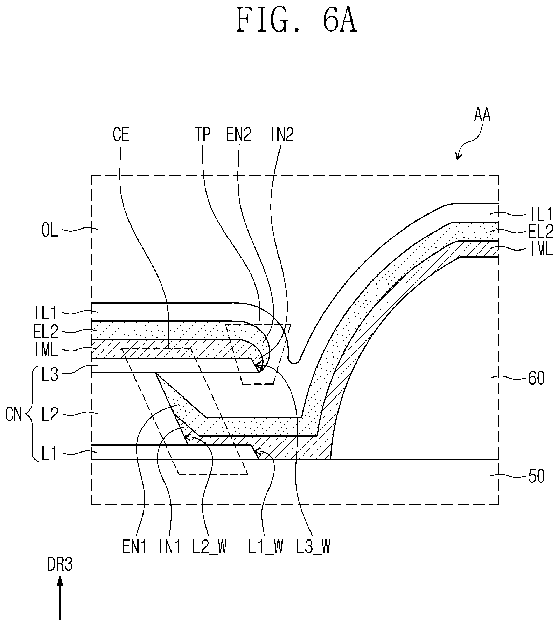

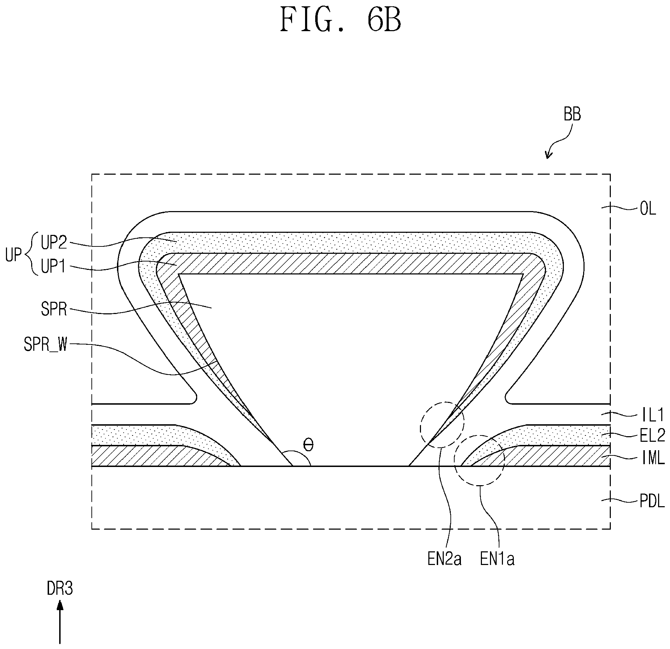

FIG. 5 is a schematic cross-sectional view of the display panel DP according to an embodiment of the disclosure. FIG. 6A is an enlarged schematic cross-sectional view of a portion of the display panel DP of FIG. 5 according to an embodiment of the disclosure. FIG. 6B is an enlarged schematic cross-sectional view of a portion of the display panel DP of FIG. 5 according to an embodiment of the disclosure. FIG. 5 is a schematic cross-sectional view taken along line I-I' of FIG. 4B. FIG. 6A is an enlarged schematic cross-sectional view of an area AA of FIG. 5, and FIG. 6B is an enlarged schematic cross-sectional view of an area BB of FIG. 5. Hereinafter, the disclosure will be described with reference to FIGS. 5 to 6B.

Referring to FIG. 5, the display panel DP may include a base layer BS, a driving device layer DDL, a light emitting device layer LDL, an encapsulation layer ECL, and a sensing layer ISL. The driving device layer DDL may include multiple insulating layers 10, 20, 30, 40, and 50 disposed on the base layer BS, multiple conductive patterns and multiple semiconductor patterns, which may be disposed between the insulating layers 10, 20, 30, 40, and 50. The conductive patterns and the semiconductor patterns disposed between the insulating layers 10, 20, 30, 40, and 50 may form the pixel driver PDC. For the convenience of explanation, FIG. 5 shows a schematic cross-section of a portion of an area in which one light emitting part may be disposed.

The base layer BS may provide a base surface on which the pixel driver PDC may be disposed. The base layer BS may be a rigid substrate or a flexible substrate that may be bendable, foldable, or rollable. The base layer BS may be a glass substrate, a metal substrate, or a polymer substrate, however, it should not be limited thereto or thereby. According to an embodiment, the base layer BS may be an inorganic layer, an organic layer, or a composite material layer.

The base layer BS may have a multi-layer structure. For instance, the base layer BS may include a first polymer resin layer, a silicon oxide (SiOₓ) layer disposed on the first polymer resin layer, an amorphous silicon (a-Si) layer disposed on the silicon oxide layer, and a second polymer resin layer disposed on the amorphous silicon (a-Si) layer. The silicon oxide (SiOₓ) layer and the amorphous silicon (a-Si) layer may be referred to as a base barrier layer.

Each of the first and second polymer resin layers may include a polyimide-based resin. In addition, each of the first and second polymer resin layers may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, and a perylene-based resin. In the disclosure, the term "X-based resin", as used herein, refers to the resin that includes a functional group of X.

Insulating layers, conductive layers, and semiconductor layers may be formed on the base layer BS through coating and deposition processes. The insulating layers, the conductive layers, and the semiconductor layers may be selectively patterned through several photolithography processes, and thus, holes may be defined through the insulating layers or the semiconductor pattern, the conductive pattern, and the signal line may be formed.

The driving device layer DDL may include first, second, third, fourth, and fifth insulating layers 10, 20, 30, 40, and 50, which may be sequentially stacked on each other on the base layer BS, and the pixel driver PDC. FIG. 5 shows one transistor TR and two capacitors C1 and C2 of the pixel driver PDC. The transistor TR may correspond to a transistor electrically connected to the light emitting device LD via the connection wiring CN, i.e., the connection transistor electrically connected to the node (the fourth node N4 of FIG. 2A or the second node N2 of FIG. 2B) corresponding to the cathode of the light emitting device LD. In detail, the transistor TR may correspond to the sixth transistor T6 of FIG. 2A or the first transistor T1 of FIG. 2B. Although not shown in the figures, other transistors forming the pixel driver PDC may have substantially the same structure as that of the transistor TR (hereinafter, referred to as the connection transistor) shown in FIG. 5, however, this may be merely an example. According to an embodiment, other transistors forming the pixel driver PDC may have a structure different from the connection transistor TR and should not be particularly limited.

The first insulating layer 10 may be disposed on the base layer BS. The first insulating layer 10 may be an inorganic layer and/or an organic layer and may have a single-layer or multi-layer structure. The first insulating layer 10 may include at least one of aluminium oxide, titanium oxide, silicon oxide, silicon nitride, silicon oxynitride, zirconium oxide, and hafnium oxide. In the embodiment, the first insulating layer 10 may have a single-layer structure of a silicon oxide layer. Insulating layers described later may be an inorganic layer and/or an organic layer and may have a single-layer or multi-layer structure. The inorganic layer may include at least one of the above-mentioned materials, however, it should not be limited thereto or thereby.

The first insulating layer 10 may cover a bottom conductive layer BCL. For example, the display panel DP may further include the bottom conductive layer BCL disposed under the connection transistor TR and overlapping the connection transistor TR. The bottom conductive layer BCL may prevent an electric potential caused by a polarization phenomenon of the base layer BS from exerting influence on the connection transistor TR. In addition, the bottom conductive layer BCL may block a light incident into the connection transistor TR from a lower side of the bottom conductive layer BCL. At least one of an inorganic barrier layer and a buffer layer may be further disposed between the bottom conductive layer BCL and the base layer BS.

The bottom conductive layer BCL may include a reflective metal material. As an example, the bottom conductive layer BCL may include titanium (Ti), molybdenum (Mo), an alloy including molybdenum (Mo), aluminium (Al), an alloy including aluminium (Al), aluminium nitride (AlN), tungsten (W), tungsten nitride (WN), and copper (Cu).

In the embodiment, the bottom conductive layer BCL may be electrically connected to a source of the connection transistor TR (or a transistor) via a source electrode pattern W1. The bottom conductive layer BCL may be synchronized with the source of the connection transistor TR, however, this may be merely an example. According to an embodiment, the bottom conductive layer BCL may be electrically connected to and synchronized with a gate of the connection transistor TR. According to an embodiment, the bottom conductive layer BCL may be electrically connected to another electrode to independently receive a constant voltage or a pulse signal. According to an embodiment, the bottom conductive layer BCL may be provided in an isolated form isolated from other conductive patterns. The bottom conductive layer BCL may be provided in a variety of shapes and should not be particularly limited.

The connection transistor TR may be disposed on the first insulating layer 10. The connection transistor TR may include a semiconductor pattern SP and a gate electrode GE. The semiconductor pattern SP may be disposed on the first insulating layer 10. The semiconductor pattern SP may include an oxide semiconductor. As an example, the oxide semiconductor may include a transparent conductive oxide (TCO), such as indium tin oxide (ITO), indium zinc oxide (IZO), indium gallium zinc oxide (IGZO), zinc oxide (ZnO), indium oxide (In₂O₃), or the like, however, the material for the semiconductor pattern SP should not be limited thereto or thereby. As an example, the semiconductor pattern may include amorphous silicon, low temperature polycrystalline silicon, or polycrystalline silicon.

The semiconductor pattern SP may include a source area SR, a drain area DR, and area channel area CR distinguished from each other depending on a degree of conductivity. The channel area CR may overlap the gate electrode GE in a plan view. The source area SR and the drain area DR may be spaced apart from each other with the channel area CR disposed therebetween. In the case that the semiconductor pattern SP may be the oxide semiconductor, each of the source area SR and the drain area DR may be a reduced area. Accordingly, the source area SR and the drain area DR may have a relatively high content of reduced metal compared with the channel area CR. According to an embodiment, in the case that the semiconductor pattern SP may be the polycrystalline silicon, each of the source area SR and the drain area DR may be a highly doped area.

The source area SR and the drain area DR may have a relatively high conductivity compared with the channel area CR. The source area SR may correspond to a source electrode of the connection transistor TR, and the drain area DR may correspond to a drain electrode of the connection transistor TR. As shown in FIG. 5, the connection transistor TR may further include the source electrode pattern W1 and a drain electrode pattern W2 separate from each other and respectively electrically connected to the source area SR and the drain area DR. In detail, each of the source and drain electrode patterns W1 and W2 and one of lines forming the pixel driver PDC of FIG. 2A or the pixel driver PDC-1 of FIG. 2B may be integral with each other, however, it should not be limited thereto or thereby.

The second insulating layer 20 may commonly overlap the pixels and may cover the semiconductor pattern SP. The second insulating layer 20 may be an inorganic layer and/or an organic layer and may have a single-layer or multi-layer structure. The second insulating layer 20 may include at least one of aluminium oxide, titanium oxide, silicon oxide, silicon nitride, silicon oxynitride, zirconium oxide, and hafnium oxide. In the embodiment, the second insulating layer 20 may have a single-layer structure of a silicon oxide layer.

The gate electrode GE may be disposed on the second insulating layer 20. The gate electrode GE may correspond to the gate of the connection transistor TR. The gate electrode GE may be disposed on the semiconductor pattern SP, however, this may be merely an example. According to an embodiment, the gate electrode GE may be disposed under the semiconductor pattern SP, and it should not be particularly limited.

The gate electrode GE may include titanium (Ti), silver (Ag), molybdenum (Mo), aluminium (Al), aluminium nitride (AlN), tungsten (W), tungsten nitride (WN), copper (Cu), or an alloy thereof, however, it should not be particularly limited.

The third insulating layer 30 may be disposed on the second insulating layer 20 and the gate electrode GE. The third insulating layer 30 may be an inorganic layer and/or an organic layer and may have a single-layer or multi-layer structure. The third insulating layer 30 may include at least one of aluminium oxide, titanium oxide, silicon oxide, silicon nitride, silicon oxynitride, zirconium oxide, and hafnium oxide.

Among conductive patterns W1, W2, CPE1, CPE2, and CPE3, a first capacitor electrode CPE1 and a second capacitor electrode CPE2 may form the first capacitor C1. The first capacitor electrode CPE1 and the second capacitor electrode CPE2 may be spaced apart from each other with the first insulating layer 10 and the second insulating layer 20 disposed therebetween.

According to an embodiment, the first capacitor electrode CPE1 and the bottom conductive layer BCL may be integrally provided with each other. In addition, the second capacitor electrode CPE2 and the gate electrode GE may be integral with each other.

A third capacitor electrode CPE3 may be disposed on the third insulating layer 30. The third capacitor electrode CPE3 may be spaced apart from the second capacitor electrode CPE2 with the third insulating layer 30 disposed therebetween and may overlap the second capacitor electrode CPE2. The third capacitor electrode CPE3 and the second capacitor electrode CPE2 may form the second capacitor C2.

The fourth insulating layer 40 may be disposed on the third insulating layer 30 and/or the third capacitor electrode CPE3. The fourth insulating layer 40 may be an inorganic layer and/or an organic layer and may have a single-layer or multi-layer structure. The fourth insulating layer 40 may include at least one of aluminium oxide, titanium oxide, silicon oxide, silicon nitride, silicon oxynitride, zirconium oxide, and hafnium oxide.

The source electrode pattern W1 and the drain electrode pattern W2 may be disposed on the fourth insulating layer 40. The source electrode pattern W1 may be electrically connected to the source area SR of the connection transistor TR via a first contact hole CNT1, and the source electrode pattern W1 and the source area SR of the semiconductor pattern SP may serve as the source of the connection transistor TR. The drain electrode pattern W2 may be electrically connected to the drain area DR of the connection transistor TR via a second contact hole CNT2, and the drain electrode pattern W2 and the drain area DR of the semiconductor pattern SP may serve as the drain of the connection transistor TR. The fifth insulating layer 50 may be disposed on the fourth insulating layer 40, the source electrode pattern W1 and the drain electrode pattern W2.

The connection wiring CN may be disposed on the fifth insulating layer 50. The connection wiring CN may electrically connect the pixel driver PDC to the light emitting device LD. For example, the connection wiring CN may electrically connect the connection transistor TR to the light emitting device LD. The connection wiring CN may be a connection node that connects the pixel driver PDC to the light emitting device LD. For example, the connection wiring CN may correspond to the fourth node N4 shown in FIG. 2A or may correspond to the second node N2 shown in FIG. 2B, however, this may be merely an example. According to an embodiment, the connection wiring CN may be defined as a connection node electrically connected to various components of the pixel driver PDC according to the design of the pixel driver PDC and should not be particularly limited as long as the connection wiring CN may be electrically connected to the light emitting device LD.

The sixth insulating layer 60 may be disposed on the connection wiring CN. The sixth insulating layer 60 may be disposed on the fifth insulating layer 50 and may cover the connection wiring CN. Each of the fifth insulating layer 50 and the sixth insulating layer 60 may be an organic layer. As an example, each of the fifth insulating layer 50 and the sixth insulating layer 60 may include a general-purpose polymer, such as benzocyclobutene (BCB), polyimide, hexamethyldisiloxane (HMDSO), polymethylmethacrylate (PMMA), or polystyrene (PS), a polymer derivative having a phenolic group, an acrylic-based polymer, an imide-based polymer, an aryl ether-based polymer, an amide-based polymer, and a fluorine-based polymer, a p-xylene-based polymer, a vinyl alcohol-based polymer, or blends thereof.

The sixth insulating layer 60 may be provided with an opening defined therethrough to expose at least a portion of the connection wiring CN. The connection wiring CN may be electrically connected to the light emitting device LD via the portion exposed without being covered by the sixth insulating layer 60. For example, the connection wiring CN may electrically connect the connection transistor TR to the light emitting device LD. This will be described in detail later. The sixth insulating layer 60 may be omitted from the display panel DP or may be provided in plural in the display panel DP, and the disclosure should not be limited thereto or thereby.

The light emitting device layer LDL may be disposed on the sixth insulating layer 60. The light emitting device layer LDL may include a pixel definition layer PDL, the light emitting device LD, and the separator SPR. The pixel definition layer PDL may be an organic layer. As an example, the pixel definition layer PDL may include a general-purpose polymer, such as benzocyclobutene (BCB), polyimide, hexamethyldisiloxane (HMDSO), polymethylmethacrylate (PMMA), or polystyrene (PS), a polymer derivative having a phenolic group, an acrylic-based polymer, an imide-based polymer, an aryl ether-based polymer, an amide-based polymer, and a fluorine-based polymer, a p-xylene-based polymer, a vinyl alcohol-based polymer, or blends thereof.

The pixel definition layer PDL may have a light absorbing property. For example, the pixel definition layer PDL may have a black color. The pixel definition layer PDL may include a black coloring agent. The black coloring agent may include a black dye or a black pigment. The black coloring agent may include a metal material, such as carbon black, chromium, or an oxide thereof. The pixel definition layer PDL may correspond to a light blocking pattern having a light blocking property.

The pixel definition layer PDL is provided with an opening (hereinafter, referred to as the light emitting opening) OP-PDL defined therethrough. The light emitting opening OP-PDL are provided in plural, and the light emitting openings OP-PDL respectively correspond to the light emitting devices LD. All components of the light emitting device LD may be disposed in the light emitting opening OP-PDL while overlapping each other, and the light emitting opening OP-PDL may correspond to an area where the light emitted from the light emitting device LD may be substantially displayed. Accordingly, the shape of the light emitting part EP (refer to FIG. 3a) may substantially correspond to the shape of the light emitting opening OP-PDL in a plan view.

The light emitting device LD may include a first electrode EL1, an intermediate layer IML including a light emitting layer EML, and a second electrode EL2. FIG. 5 shows one light emitting device LD, however, the light emitting device LD may be provided in plural, and each of the light emitting devices LD may include the first electrode EL1, the intermediate layer IML including the light emitting layer EML, and the second electrode EL2. According to an embodiment, the first electrodes EL1 of the light emitting devices LD may be provided integrally with each other. The intermediate layers IML of the light emitting devices LD may be separated from each other by the separator SPR, and the second electrodes EL2 of the light emitting devices LD are separated from each other by the separator SPR.

The first electrode EL1 may be a semi-transmissive electrode, a transmissive electrode, or a reflective electrode. According to an embodiment, the first electrode EL1 may include a reflective layer formed of silver (Ag), magnesium (Mg), aluminium (Al), platinum (Pt), palladium (Pd), gold (Au), nickel (Ni), neodymium (Nd), iridium (Ir), chromium (Cr), or compounds thereof and a transparent or semi-transparent electrode layer formed on the reflective layer. The transparent or semi-transparent electrode layer may include at least one selected from the group consisting of indium tin oxide (ITO), indium zinc oxide (IZO), indium gallium zinc oxide (IGZO), zinc oxide (ZnO), indium oxide (In₂O₃), and aluminium-doped zinc oxide (AZO). For instance, the first electrode EL1 may have a stack structure of ITO/Ag/ITO.

In the embodiment, the first electrode EL1 may be the anode of the light emitting device LD. For example, the first electrode EL1 may be electrically connected to the first power line VDL (refer to FIG. 2A) and may receive the first power supply voltage VDD (refer to FIG. 2A). The first electrode EL1 may be electrically connected to the first power line VDL in the display area DA (refer to FIG. 3A or 3B) or may be electrically connected to the first power line VDL in the peripheral area NDA. In the case where the first electrode EL1 may be electrically connected to the first power line VDL in the peripheral area NDA, the first power line VDL may be disposed in the peripheral area NDA, and the first electrode EL1 may extend to the peripheral area NDA.

FIG. 5 shows the structure in which the first electrode EL1 overlaps the light emitting opening OP-PDL but does not overlap the separator SPR, however, it should not be limited thereto or thereby. As described above, the first electrodes EL1 of the light emitting devices may have an integral shape and may have a mesh or lattice shape in which openings may be defined in some areas as shown in FIG. 4C. For example, the first electrode EL1 may have a variety of shapes as long as the light emitting devices receive the same first power supply voltage VDD through their first electrodes EL1, however, it should not be limited thereto or thereby.

The intermediate layer IML is disposed between the first electrode EL1 and the second electrode EL2. The intermediate layer IML may include the light emitting layer EML and a functional layer FNL, however, this may be merely an example. According to an embodiment, the light emitting device LD may include the intermediate layer IML with various structures and should not be particularly limited. As an example, the functional layer FNL may include multiple layers or may include two or more layers spaced apart from each other with the light emitting layer EML disposed therebetween. According to an embodiment, the functional layer FNL may be omitted.

The light emitting layer EML may include an organic light emitting material. In addition, the light emitting layer EML may include an inorganic light emitting material or may include a layer obtained by mixing the organic light emitting material with the inorganic light emitting material. In the embodiment, the light emitting layers EML respectively included in the light emitting parts EP adjacent to each other may include light emitting materials displaying different colors from each other. As an example, the light emitting layer EML included in each of the light emitting parts may emit the light having at least one of blue, red, and green colors, however, it should not be limited thereto or thereby. According to an embodiment, the light emitting layer EML included in all the light emitting parts EP may include the light emitting materials displaying the same color. The light emitting layer EML may provide a blue light or a white light. In addition, the light emitting layer EML and the functional layer FNL have different shapes from each other in FIG. 5, however, the disclosure should not be limited thereto or thereby. According to an embodiment, the light emitting layer EML may have substantially the same shape as that of the functional layer FNL in a plan view.

The functional layer FNL may be disposed between the first electrode EL1 and the second electrode EL2. In detail, the functional layer FNL may be disposed between the first electrode EL1 and the light emitting layer EML or may be disposed between the second electrode EL2 and the light emitting layer EML. According to an embodiment, the functional layer FNL may be disposed between the first electrode EL1 and the light emitting layer EML and between the second electrode EL2 and the light emitting layer EML. In the embodiment, the light emitting layer EML may be inserted into the functional layer FNL, however, this may be merely an example. According to an embodiment, the functional layer FNL may include a layer disposed between the light emitting layer EML and the first electrode EL1 and/or a layer disposed between the light emitting layer EML and the second electrode EL2, and each of the layers may be provided in plural. However, they should not be limited thereto or thereby.

The functional layer FNL may control a movement of electric charges. The functional layer FNL may include a hole injection/transport material and/or an electron injection/transport material. The functional layer FNL may include at least one of an electron block layer, a hole transport layer, a hole injection layer, a hole block layer, an electron transport layer, an electron injection layer, and an electric charge generation layer.

The second electrode EL2 may be disposed on the intermediate layer IML. As described above, the second electrode EL2 may be electrically connected to the connection wiring CN and may be electrically connected to the pixel driver PDC. In the embodiment, the second electrode EL2 may be electrically connected to the connection transistor TR via the connection wiring CN.

As described above, the connection wiring CN may include the driver connection part CD and the light emitting connection part CE. The driver connection part CD of the connection wiring CN may be electrically connected to the pixel driver PDC and may be substantially electrically connected to the connection transistor TR. In the embodiment, the driver connection part CD may be electrically connected to the drain area DR of the semiconductor pattern SP via the drain electrode pattern W2 after penetrating through the fifth insulating layer 50. The light emitting connection part CE of the connection wiring CN may be electrically connected to the light emitting device LD. The light emitting connection part CE may be defined in an area exposed without being covered by the sixth insulating layer 60, and the second electrode EL2 may be in contact (e.g., directly in contact) with the light emitting connection part CE. The tip part TP may be defined in the light emitting connection part CE.

The light emitting connection part CE of the connection wiring CN will be described in more detail with reference to FIGS. 5 and 6A. As shown in FIGS. 5 and 6A, the connection wiring CN may have a three-layer structure. In detail, the connection wiring CN may include a first layer L1, a second layer L2, and a third layer L3, which may be sequentially stacked on each other in a third direction DR3. The second layer L2 may include a material different from that of the first layer L1. In addition, the second layer L2 may include a material different from that of the third layer L3. The second layer L2 may have a relatively thicker thickness than that of the first layer L1. In addition, the second layer L2 may have a relatively thicker thickness than that of the third layer L3. The second layer L2 may include a material with high conductivity. As an example, the second layer L2 may include aluminium (Al).

The first layer L1 may include a material having an etch rate lower than that of the second layer L2. For example, the second layer L2 may include a material having a higher etch selectivity with respect to the first layer L1. As an example, the first layer L1 may include titanium (Ti), and the second layer L2 may include aluminium (Al). A side surface L1_W of the first layer L1 may be defined outside a side surface L2_W of the second layer L2. For example, the light emitting connection part CE of the connection wiring CN may have a shape in which the side surface L1_W of the first layer L1 protrudes outward from the side surface L2_W of the second layer L2. For example, the light emitting connection part CE of the connection wiring CN may have a shape in which the side surface L2_W of the second layer L2 may be recessed inward from the side surface L1_W of the first layer L1.

The third layer L3 may include a material having an etch rate lower than that of the second layer L2. For example, the third layer L3 and the second layer L2 may include materials having different etch selectivity with respect to each other. As an example, the third layer L3 may include titanium (Ti), and the second layer L2 may include aluminium (Al). A side surface L3_W of the third layer L3 may be defined outside the side surface L2_W of the second layer L2. For example, the light emitting connection part CE of the connection wiring CN may have a shape in which the side surface L3_W of the third layer L3 protrudes outward from the side surface L2_W of the second layer L2. In other words, the light emitting connection part CE of the connection wiring CN may have an undercut shape or an overhang structure, and the tip part TP of the light emitting connection part CE may be defined by a portion of the third layer L3, which may be more protruded than the second layer L2.

At least a portion of the tip part TP and at least a portion of the side surface L2_W of the second layer L2 may be exposed without being covered by the sixth insulating layer 60 and the pixel definition layer PDL. In detail, a first opening OP1 may be defined through the sixth insulating layer 60 to expose one side of the connection wiring CN, and a second opening OP2 may be defined through the pixel definition layer PDL to overlap the first opening OP1. The second opening OP2 may have a size equal to or greater than the first opening OP1 in a plan view, however, the disclosure should not be limited thereto or thereby. According to an embodiment, the size of the second opening OP2 may be smaller than or equal to that of the first opening OP1 in a plan view as long as at least the portion of the tip part TP and at least the portion of the side surface L2_W of the second layer L2 may be exposed.

The intermediate layer IML may be disposed on the pixel definition layer PDL. The intermediate layer IML may be disposed on some areas of the sixth insulating layer 60 exposed through the second opening OP2 of the pixel definition layer PDL. In addition, the intermediate layer IML may also be disposed on some areas of the connection wiring CN exposed through the first opening OP1 of the sixth insulating layer 60. As shown in FIG. 6A, the intermediate layer IML may include an end IN1 disposed along an upper surface of the fifth insulating layer 50 and another end IN2 disposed along an upper surface of the connection wiring CN and an upper surface of the tip part TP. For example, in the case that it is viewed in the cross-section, the intermediate layer IML may be partially disconnected based on the tip part TP in the area where the light emitting connection part CE is defined. However, in a plan view, the intermediate layer IML may have an integral shape extended as a whole within the area (refer to FIG. 4) defined as a closed line by the separator SPR.

The second electrode EL2 may be disposed on the intermediate layer IML. The second electrode EL2 may be disposed on some areas of the sixth insulating layer 60 exposed through the second opening OP2 of the pixel definition layer PDL. In addition, the second electrode EL2 may also be disposed on some areas of the connection wiring CN exposed through the first opening OP1 of the sixth insulating layer 60. As shown in FIG. 6A, the second electrode EL2 may include an end EN1 disposed along the upper surface of the fifth insulating layer 50 and another end EN2 disposed along the upper surface of the connection wiring CN and the upper surface of the tip part TP. For example, in the case that it is viewed in a cross-section, the second electrode EL2 may be partially disconnected based on the tip part TP in the area where the light emitting connection part CE is defined. However, in a plan view, the second electrode EL2 may have an integral shape extended as a whole within the area (refer to FIG. 4) defined as a closed line by the separator SPR.

The end EN1 of the second electrode EL2 may be disposed along the side surface L2_W of the second layer L2 and may be in contact with the side surface L2_W of the second layer L2. In detail, due to a difference in deposition angle between the second electrode EL2 and the intermediate layer IML, the second electrode EL2 may be in contact with the side surface L2_W of the second layer L2 exposed without being covered by the intermediate layer IML by the tip part TP. For example, the second electrode EL2 may be electrically connected to the connection wiring CN without a separate patterning process for the intermediate layer IML, and thus, the light emitting device LD may be electrically connected to the pixel driver PDC via the connection wiring CN.

According to the embodiment, another end IN2 of the intermediate layer IML and another end EN2 of the second electrode EL2 may cover the side surface L3_W of the third layer L3, however, this may be merely an example. According to an embodiment, at least a portion of the side surface L3_W of the third layer L3 may be exposed without being covered by another end IN2 of the intermediate layer IML and/or another end EN2 of the second electrode EL2.

As described above, the display panel DP includes the separator SPR. The separator SPR is disposed on the pixel definition layer PDL. The second electrode EL2 and the intermediate layer IML may be commonly formed in the pixels using an open mask. The second electrode EL2 and the intermediate layer IML may be divided into portions by the separator SPR. As described above, the separator SPR may have a closed line form for each light emitting part, and thus, the second electrode EL2 and the intermediate layer IML may be divided into plural portions to be respectively disposed in each of the light emitting parts EP. For example, the second electrode EL2 and the intermediate layer IML may be disposed in each pixel and may be electrically isolated from other second electrodes EL2 and other intermediate layers IML, which may be disposed in other pixels adjacent thereto.

The separator SPR will be described in detail with reference to FIGS. 5 and 6B. The separator SPR may have a reverse-tapered shape as shown in FIG. 6B. For example, an angle θ (hereinafter, referred to as a taper angle) between an upper surface of the pixel definition layer PDL and a side surface SPR_W of the separator SPR may be an obtuse angle, however, this may be merely an example. The taper angle θ of the separator SPR may be set in various ways as long as the second electrode EL2 placed in each pixel may be electrically disconnected from other second electrode EL2 placed in other pixels by the separator SPR. In addition, the separator SPR may have the same structure as the tip part TP, and the disclosure should not be particularly limited.

The separator SPR may include a material having an insulating property, and particularly, may include an organic insulating material. The separator SPR may include an inorganic insulating material or may have a multi-layer structure of an organic insulating material and an inorganic insulating material. According to an embodiment, the separator SPR may include a conductive material. For example, the material of the separator SPR should not be particularly limited as long as the second electrode EL2 placed in each pixel may be electrically disconnected from the second electrode placed in other pixels.

A dummy layer UP may be disposed on the separator SPR. The dummy layer UP may include a first dummy layer UP1 disposed on the separator SPR and a second dummy layer UP2 disposed on the first dummy layer UP1. The first dummy layer UP1 and the intermediate layer IML may be formed through a same process and may include a same material. The second dummy layer UP2 and the second electrode EL2 may be formed through a same process and may include a same material. For example, the first dummy layer UP1 and the second dummy layer UP2 may be formed during the manufacturing process of the intermediate layer IML and the second electrode EL2. According to an embodiment, the display panel DP may not include the dummy layer UP.

As shown in FIG. 6B, the second electrode EL2 may include a first end EN1a, and the second dummy layer UP2 may include a second end EN2a. The first end EN1a may be spaced apart from the separator SPR and may be disposed on the pixel definition layer PDL. The second end EN2a may be separated from the first end EN1a and may be disposed on the side surface SPR_W of the separator SPR. FIG. 6B shows a structure in which the first end EN1a may be spaced apart from the side surface SPR_W of the separator SPR by a distance, however, the disclosure should not be limited thereto or thereby. According to an embodiment, the first end EN1a may be in contact with the side surface SPR_W of the separator SPR as long as the first end EN1a is electrically disconnected from the second end EN2a. In addition, although the first end EN1a and the second end EN2a may be physically connected to each other without being distinguished from each other, the second electrode EL2 may be determined as being divided by the separator SPR in the case that a portion of the second electrode EL2 and a portion of the second dummy layer UP2 formed along the side surface SPR_W of the separator SPR have a thin thickness and a high electrical resistance and the second electrode EL2 may not be electrically connected to other second electrodes of the pixels adjacent thereto.

According to the disclosure, as the second electrode EL2 or the intermediate layer IML may not be formed or may be formed thinly on the side surface SPR_W of the separator SPR, the second electrode EL2 or the intermediate layer IML may be divided for each pixel even though a separate patterning process using a mask may not be performed. According to an embodiment, the shape of the separator SPR may be changed in various ways as long as the second electrode EL2 or the intermediate layer IML may be electrically disconnected between the pixels adjacent to each other and should not be particularly limited.

Referring to FIG. 5 again, the encapsulation layer ECL may be disposed on the light emitting device layer LDL. The encapsulation layer ECL may cover the light emitting device LD and may cover the separator SPR. The encapsulation layer ECL may include a first inorganic layer IL1, an organic layer OL, and a second inorganic layer IL2, which may be sequentially stacked on each other, however, it should not be limited thereto or thereby. According to an embodiment, the encapsulation layer ECL may further include multiple inorganic layers and organic layers. In addition, the encapsulation layer ECL may be a glass substrate.

The first and second inorganic layers IL1 and IL2 may protect the light emitting device LD from moisture and oxygen from the outside of the display panel DP, and the organic layer OL may protect the light emitting device LD from a foreign substance such as particles remaining in a process of forming of the first inorganic layer II,1. The first and second inorganic layers IL1 and IL2 may include a silicon nitride layer, a silicon oxynitride layer, a silicon oxide layer, a titanium oxide layer, or an aluminium oxide layer. The organic layer OL may include an acrylic-based organic layer, however, it should not be particularly limited.

The sensing layer ISL may sense external inputs. The sensing layer ISL may be formed on the encapsulation layer ECL through successive processes. The sensing layer ISL may be disposed on (e.g., disposed directly on) the encapsulation layer ECL. In the disclosure, the expression "The sensing layer ISL may be disposed (e.g., disposed directly on) on the encapsulation layer ECL" means that no intervening elements may be between the sensing layer ISL and the encapsulation layer ECL. For example, a separate adhesive member may not be disposed between the sensing layer ISL and the encapsulation layer ECL, however, this may be merely an example. According to an embodiment, the sensing layer ISL may be provided after being separately formed to be coupled to the display panel DP by an adhesive member, but it should not be limited thereto or thereby.

The sensing layer ISL may include multiple conductive layers and multiple insulating layers. The conductive layers may include a first sensing conductive layer MTL1 and a second sensing conductive layer MTL2, and the insulating layers may include first, second, and third sensing insulating layers 71, 72, and 73. However, this may be merely an example, and the number of conductive layers and the number of insulating layers should not be particularly limited.

Each of the first, second, and third sensing insulating layers 71, 72, and 73 may have a single-layer structure or a multi-layer structure of layers stacked on each other in the third direction DR3. The first, second, and third sensing insulating layers 71, 72, and 73 may include an inorganic layer. The inorganic layer may include at least one of aluminium oxide, titanium oxide, silicon oxide, silicon nitride, silicon oxynitride, zirconium oxide, and hafnium oxide. The first, second, and third sensing insulating layers 71, 72, and 73 may include an organic layer. The organic layer may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyimide-based resin, a polyamide-based resin, and a perylene-based resin.

The first sensing conductive layer MTL1 may be disposed between the first sensing insulating layer 71 and the second sensing insulating layer 72, and the second sensing conductive layer MTL2 may be disposed between the second sensing insulating layer 72 and the third sensing insulating layer 73. A portion of the second sensing conductive layer MTL2 may be electrically connected to the first sensing conductive layer MTL1 via a contact hole CNT formed through the second sensing insulating layer 72. Each of the first and second sensing conductive layers MTL1 and MTL2 may have a single-layer structure or a multi-layer structure of layers stacked on each other in the third direction DR3.

The sensing conductive layer having the single-layer structure may include a metal layer or a transparent conductive layer. The metal layer may include molybdenum, silver, titanium, copper, aluminium, alloys thereof, or a combination thereof. The transparent conductive layer may include a transparent conductive oxide, such as indium tin oxide (ITO), indium zinc oxide (IZO), zinc oxide (ZnO), indium zinc tin oxide (IZTO), the like, or a combination thereof. In addition, the transparent conductive layer may include conductive polymer such as PEDOT, metal nanowire, graphene, the like, or a combination thereof.

The sensing conductive layer having the multi-layer structure may include metal layers. The metal layers may have a three-layer structure of titanium/aluminium/titanium. The sensing conductive layer having the multi-layer structure may include at least one metal layer and at least one transparent conductive layer.

The first sensing conductive layer MTL1 and the second sensing conductive layer MTL2 may form a sensor to sense the external inputs in the sensing layer ISL. The sensor may be driven in a capacitive method, e.g., a mutual capacitive method or a self-capacitive method, however, this is merely an example. According to an embodiment, the sensor may be driven in a resistive film method, an ultrasonic method, or an infrared method rather than the capacitive method, and it should not be particularly limited.

Each of the first sensing conductive layer MTL1 and the second sensing conductive layer MTL2 may include a transparent conductive oxide or may have a metal mesh shape formed of an opaque conductive material. The first sensing conductive layer MTL1 and the second sensing conductive layer MTL2 may include various materials and various shapes as long as a visibility of the image displayed by the display panel DP is not deteriorated.

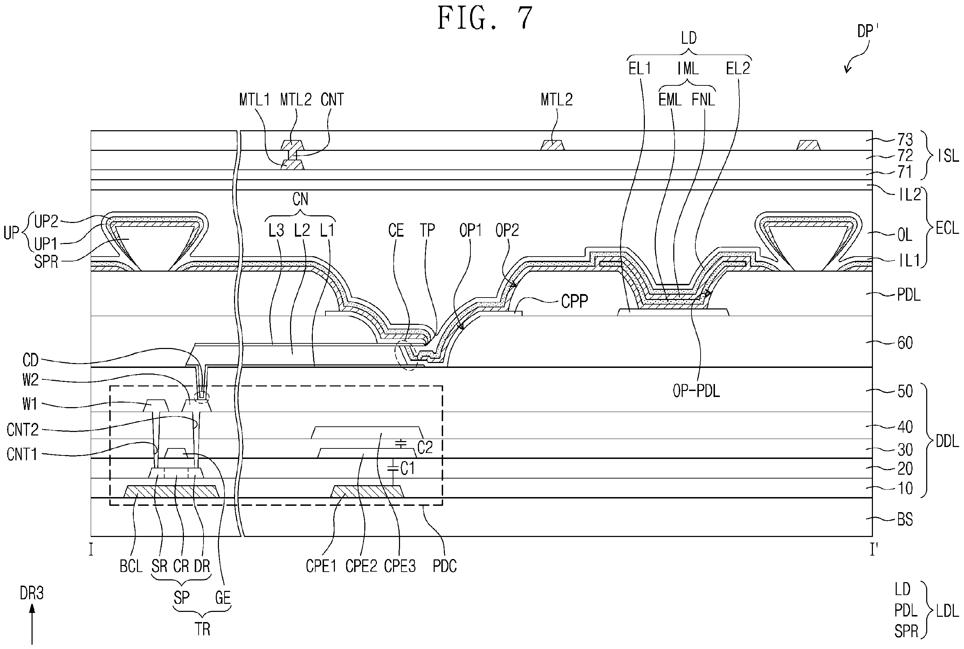

FIG. 7 is a schematic cross-sectional view of a display panel DP' according to an embodiment of the disclosure. For the convenience of explanation, FIG. 7 shows a cross-section of an area corresponding to that of FIG. 5. Hereinafter, in FIG. 7, the same reference numerals denote the same elements in FIGS. 1 to 6B, and thus, detailed descriptions of the same elements will be omitted.

The display panel DP' shown in FIG. 7 may further include a capping pattern CPP compared with the display panel DP shown in FIG. 5. The capping pattern CPP may be disposed on a sixth insulating layer 60. In addition, the capping pattern CPP may also be disposed on a portion of a connection wiring CN, which may be exposed via a first opening OP1 defined through the sixth insulating layer 60. The capping pattern CPP may be disposed to overlap the connection wiring CN. In detail, the capping pattern CPP may be disposed to overlap a light emitting connection part CE and/or a tip part TP.

As shown in FIG. 7, the capping pattern CPP may be partially disconnected based on the tip part TP in an area where the light emitting connection part CE may be defined in a cross-sectional view. However, in a plan view, the capping pattern CPP may have an integral shape that may be electrically connected as a whole in an area defined as a closed line (refer to FIG. 4B) by a separator SPR. An end of the capping pattern CPP that may be partially disconnected may be in contact with a side surface of a second layer L2 of the connection wiring CN, and another end of the capping pattern CPP may be disposed on a third layer L3 of the connection wiring CN to cover the tip part TP.

The capping pattern CPP may include a conductive material. Accordingly, a second electrode EL2 may be electrically connected to the connection wiring CN through the capping pattern CPP. For example, the capping pattern CPP may be in contact with the side surface of the second layer L2 of the connection wiring CN, the second electrode EL2 may be in contact with the capping pattern CPP, and thus, the capping pattern CPP, the second layer L2 of the connection wiring CN, and the second electrode EL2 may be electrically connected to each other. As the capping pattern CPP may be located relatively adjacent to the light emitting device LD compared to the second layer L2 of the connection wiring, the second electrode EL2 may be electrically connected to the second layer L2 by only being in contact with the capping pattern CPP instead of being in contact with the side surface of the second layer L2, and thus, the connection wiring CN and the second electrode EL2 may be more readily electrically connected to each other.

The capping pattern CPP may include a material with a relatively low reactivity compared with the second layer L2 of the connection wiring CN. As an example, the capping pattern CPP may include copper (Cu), silver (Ag), a transparent conductive oxide, the like, or a combination thereof. As the side surface of the second layer L2 of the connection wiring CN may be protected by the capping pattern CPP with the relatively low reactivity, an oxidation of materials included in the second layer L2 may be prevented. Further, during an etching process of patterning a first electrode EL1, a component such as silver (Ag) contained in the first electrode EL1 may be prevented from being reduced and remaining as particles causing defects.

The capping pattern CPP and the first electrode EL1 may be formed through a same process and may include a same material, however this is merely an example. According to an embodiment, the capping pattern CPP and the first electrode EL1 may be formed through different processes and may include different materials.

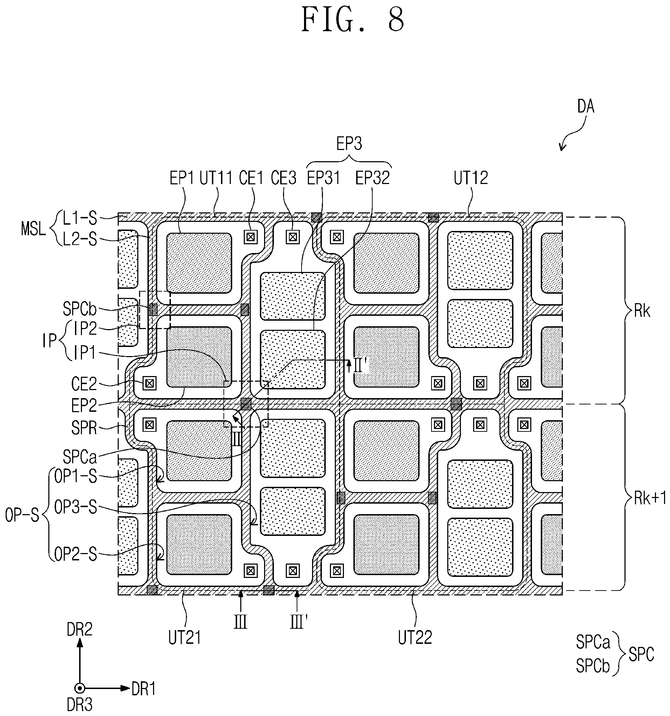

FIG. 8 is an enlarged plan view of an area of the display panel DP (refer to FIG. 1) according to an embodiment of the disclosure. FIG. 8 is a plan view showing a portion corresponding to that of FIG. 4A. FIG. 8 shows a portion of the display area DA corresponding to that of FIG. 4A. For the convenience of explanation, FIG. 8 shows only the separator SPR, the spacers SPC, the light emitting parts EP1, EP2, and EP3, and the light emitting connection parts CE1, CE2, and CE3 among the components of the display panel DP (refer to FIG. 1). Hereinafter, an arrangement of the spacers SPC in a plan view will be described in detail with reference to FIG. 8. In FIG. 8, the same/similar reference numerals denote the same/similar elements in FIGS. 4A to 7, and thus, detailed descriptions of the same/similar elements will be omitted.

According to the disclosure, each of the spacers SPC may overlap a portion of the separator SPR in a plan view. In the embodiment, each of the spacers SPC may overlap the separator SPR in a plan view.

Intersecting portions IP defined by first lines L1-S and second lines L2-S intersecting the first lines L1-S may be defined in the separator SPR. In the embodiment, the intersecting portions IP may include first intersecting portions IP1 and second intersecting portions IP2. The first intersecting portion IP1 may have a cross shape in a plan view, and the second intersecting portion IP2 may have a T-shape in a plan view.

In the embodiment, each of the spacers SPC may overlap one of the intersecting portions IP of the separator SPR. In more detail, some spacers SPCa of the spacers SPC may overlap the first intersecting portions IP1, and another spacers SPCb of the spacers SPC may overlap the second intersecting portions IP2.

In the embodiment, the spacers SPC may be disposed to overlap only some intersecting portions of the intersecting portions IP of the separator SPR. The spacers SPC may overlap the some intersecting portions, respectively. For example, some of the first intersecting portions IP1 and some of the second intersecting portions IP2 may respectively overlap the spacers SPC, and another of the first intersecting portions IP1 and another of the second intersecting portions IP2 may not overlap the spacers SPC. However, the number and positions of the spacers SPC should not be limited to those shown in FIG. 8.

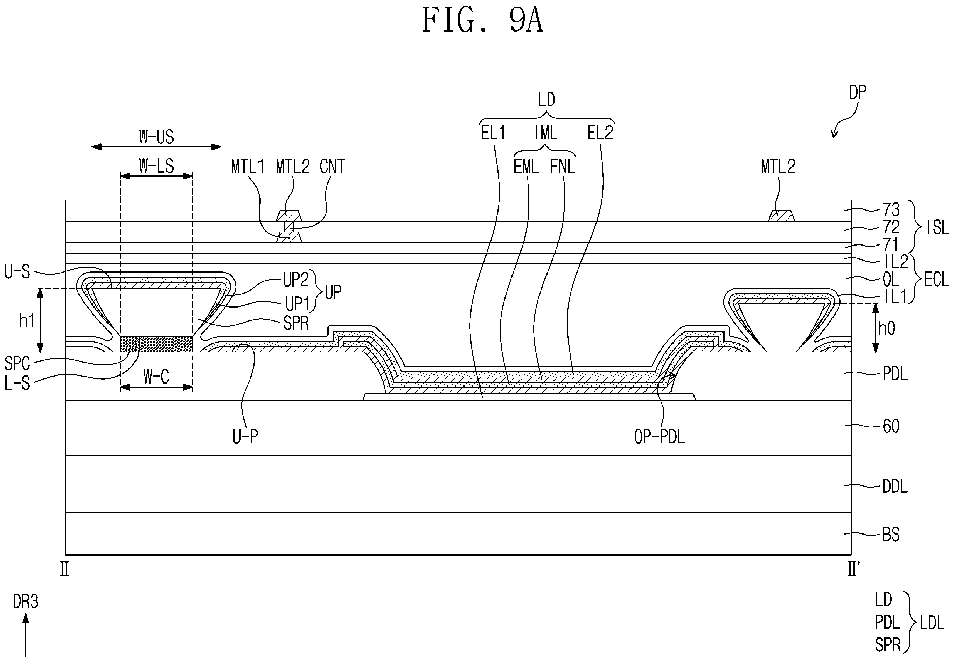

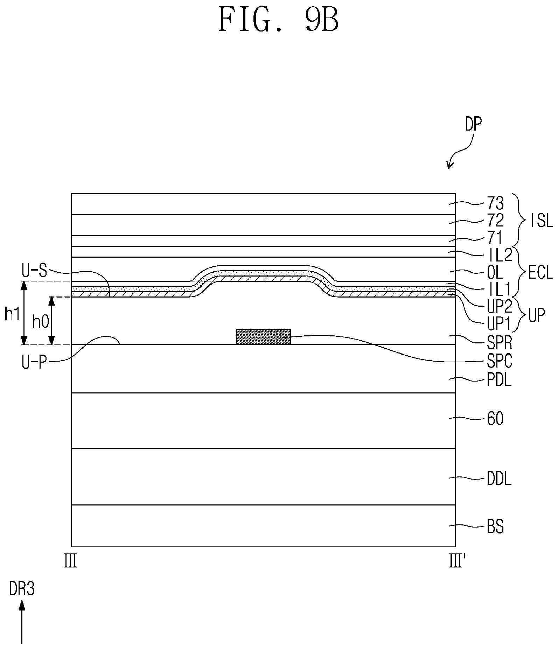

FIG. 9A is an enlarged schematic cross-sectional view of an area of the display panel DP taken along line II-II' of FIG. 8 according to an embodiment of the disclosure. FIG. 9B is an enlarged schematic cross-sectional view of an area of the display panel DP taken along line III-III' of FIG. 8 according to an embodiment of the disclosure. In FIGS. 9A and 9B, the same/similar reference numerals denote the same/similar elements in FIGS. 5 to 8, and thus, detailed descriptions of the same/similar elements will be omitted.

Referring to FIG. 9A, the spacer SPC may be disposed between the pixel definition layer PDL and the separator SPR. For example, the spacer SPC may be disposed on (e.g., disposed directly on) an upper surface U-P of the pixel definition layer PDL and may be disposed under the separator SPR.

The separator SPR may include a lower surface L-S adjacent to the pixel definition layer PDL and an upper surface U-S opposite to the lower surface L-S. As the separator SPR has a reverse-tapered shape, a width W-US of the upper surface U-S of the separator SPR may be greater than a width W-LS of the lower surface L-S of the separator SPR in a cross-sectional view.

In a cross-sectional view, a width W-C in one direction of the spacer SPC may be equal to or smaller than the width W-US in the one direction of the upper surface U-S of the separator SPR. In a plan view, an entire area of the spacer SPC may overlap the separator SPR. In other words, the spacer SPC may not be exposed while being covered by the separator SPR.

According to the embodiment, as the spacer SPC may be disposed under the separator SPR, the width W-C in the one direction of the spacer SPC may be equal to or greater than the width W-LS in the one direction of the lower surface L-S of the separator SPR. FIG. 9A shows the structure in which the width W-C in the one direction of the spacer SPC may be substantially equal to the width W-LS in the one direction of the lower surface L-S of the separator SPR.

FIG. 9B shows the schematic cross-sectional view of the display panel DP taken along an extension direction of the separator SPR. Referring to FIG. 9B, in a cross-sectional view taken along the extension direction of the separator SPR, the separator SPR may cover the spacer SPC while extending. The upper surface U-S of the separator SPR may include a portion protruding to the encapsulation layer ECL by the spacer SPC in the thickness direction. FIG. 9B shows the structure in which the upper surface U-S of the separator SPR protruded by the spacer SPC includes an approximately flat portion as a representative example, however, the upper surface U-S of the separator SPR may have a dome shape as a whole and may protrude without an approximately flat part depending on the width of the spacer SPC.

In the embodiment, a portion of the upper surface U-S of the separator SPR that overlaps the spacer SPC may be spaced-apart further from the pixel definition layer PDL than a portion of the upper surface U-S of the separator SPR that does not overlap the spacer SPC. For example, a height h1 from the upper surface U-P of the pixel definition layer PDL to a portion of the upper surface U-S of the separator SPR that overlaps the spacer SPC may be greater than a height h0 from the upper surface U-P of the pixel definition layer PDL to a portion of the upper surface U-S of the separator SPR that does not overlap the spacer SPC.

In the manufacturing process of the display panel DP, the light emitting layer EML may be formed by a process of depositing the light emitting material using a fine metal mask (FMM). Accordingly, the light emitting material may be deposited for each pixel, and thus, the light emitting layer EML patterned for each pixel may be formed. According to the embodiment, in the case that the light emitting layer EML is formed, the fine metal mask may be disposed on the separator SPR and may be supported by the separator SPR. As the upper surface U-S of the separator SPR includes the portion protruding in the thickness direction in the area overlapping the spacer SPC in a plan view, the fine metal mask may be in contact with the portion of the upper surface U-S of the separator SPR that protrudes upward due to the presence of the underlying spacer SPC.

On the other hand, different from the embodiment, in a case where the spacer SPC may not be disposed under the separator SPR, the upper surface U-S of the separator SPR may be entirely flat. Accordingly, in the forming of the light emitting layer EML, the fine metal mask may be entirely in contact with the upper surface U-S of the separator SPR.

According to the disclosure, as the spacer SPC overlapping the separator SPR may be disposed under the separator SPR, a contact area between the fine metal mask and the upper surface U-S of the separator SPR may be reduced as compared with the case where the spacer SPC is not disposed. Accordingly, it may be possible to reduce a degree of damage to the separator SPR caused by a dent defect of the fine metal mask. Accordingly, a reliability of the separator SPR may be improved after the formation of the light emitting layer EML.

In the case where the damage occurs in the separator after the light emitting layer is formed, the first inorganic layer may not be able to seal the damaged portion of the separator during a subsequent process of forming the first inorganic layer of the encapsulation layer. As an example, a seam may be formed in the first inorganic layer by the damaged portion of the separator, and the first inorganic layer may be cracked. Moisture or oxygen may enter the light emitting layer, a foreign substance may enter the light emitting layer, and as a result, defects in light emission may occur in the final product.

According to the embodiment, as the separator SPR with the improved reliability may be provided after the process of forming the light emitting layer EML, defects of the first inorganic layer IL1 may be reduced or prevented. Accordingly, the moisture, oxygen, or foreign substance may be prevented from entering the light emitting layer EML. Therefore, the process reliability may be improved, and defects in light emission of the display device DD (refer to FIG. 1) may be reduced or prevented.

According to the embodiment, as the number and/or area of the spacers SPC may be adjusted, the area of the upper surface U-S of the separator SPR that may be in contact with the fine metal mask may be controlled. For example, in the case that controlling the area of the upper surface U-S of the separator SPR that may be in contact with the fine metal mask to sufficiently support the fine metal mask and to minimize the damage of the separator, restrictions in controlling the area may be minimized.

The display panel DP according to the embodiment may include the separator SPR through which the division openings OP-S (refer to FIG. 4A) may be defined to provide the cathodes EL2_1, EL2_2, and EL2_3 (refer to FIG. 4B) separated from each other for each pixel. Accordingly, the separator SPR may have a mesh shape surrounding each of the light emitting parts EP1, EP2, andEP3 (refer to FIG. 4B), i.e., the light emitting areas. According to the embodiment, as the spacer SPC may be disposed to overlap the separator SPR, an additional space to place the spacer SPC may not be required, and the size of the light emitting area may not be reduced even though the spacer SPC may be provided.

The spacer SPC may include an organic material. As an example, the spacer SPC may include polyimide (PI).

The spacer SPC may be formed by coating, patterning, and curing the organic material. After the spacer SPC may be formed, the separator SPR may be formed. According to an embodiment, the separator SPR may also be formed by coating, patterning, and curing an organic material. However, the method of forming the spacer SPC and the separator SPR should not be limited thereto or thereby.

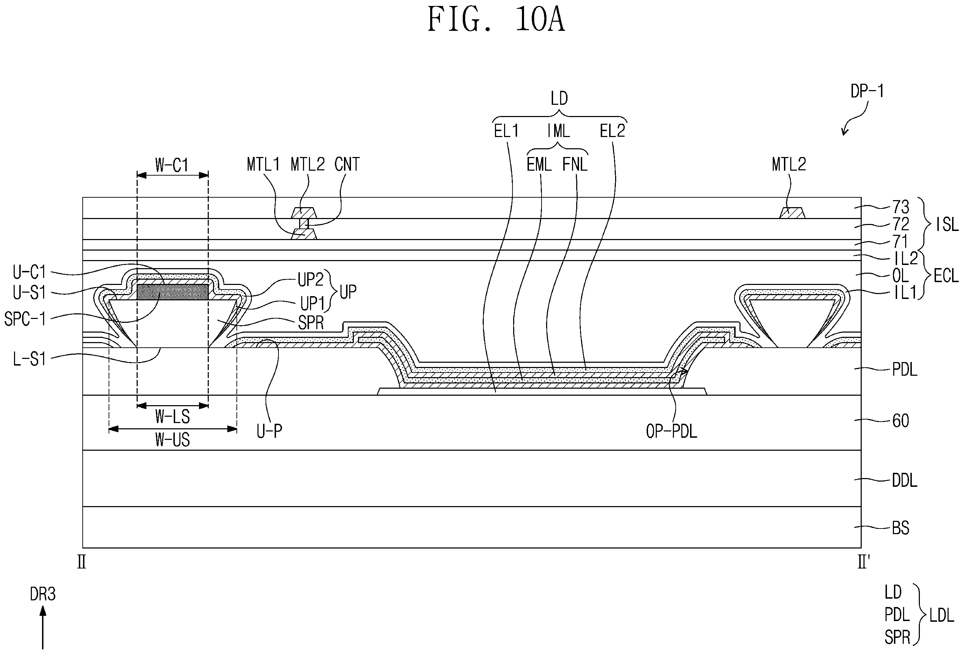

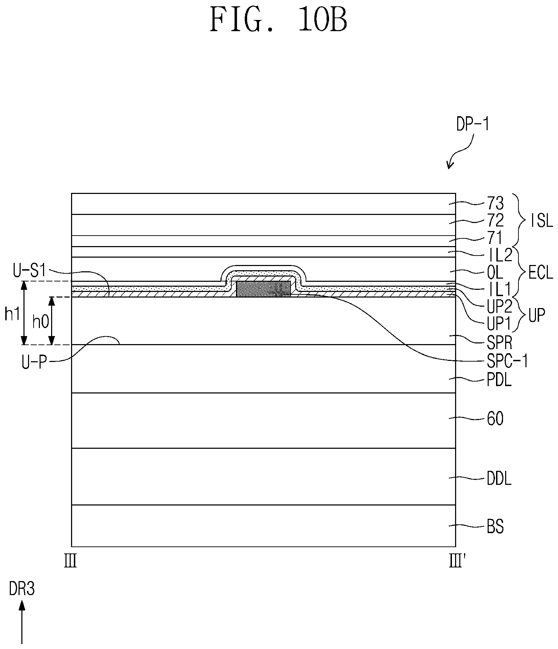

FIGS. 10A and 10B are enlarged schematic cross-sectional views of an area of a display panel DP-1 according to an embodiment of the disclosure. FIG. 10A is an enlarged schematic cross-sectional view of the area of the display panel DP-1 taken along line II-II' of FIG. 8 according to an embodiment of the disclosure. FIG. 10B is an enlarged schematic cross-sectional view of the area of the display panel DP-1 taken along line III-III' of FIG. 8 according to an embodiment of the disclosure. In FIGS. 10A and 10B, the same/similar reference numerals denote the same/similar elements in FIGS. 5 to 9B, and thus, detailed descriptions of the same/similar elements will be omitted.

Referring to FIGS. 10A and 10B, a spacer SPC-1 may be disposed on a separator SPR. The spacer SPC-1 may be disposed on (e.g., disposed directly on) an upper surface U-S1 of the separator SPR.

In the case that it is viewed in a cross-section, a width W-C1 in a direction of the spacer SPC-1 may be equal to or smaller than a width W-US in the a direction of the upper surface U-S1 of the separator SPR. In a plan view, an entire area of the spacer SPC-1 may overlap the separator SPR.

As the spacer SPC-1 may be disposed on the separator SPR, the width W-C1 in the one direction of the spacer SPC-1 may be equal to or smaller than a width W-LS in the one direction of a lower surface L-S1 of the separator SPR. FIG. 10A shows the structure in which the width W-C1 in the one direction of the spacer SPC-1 may be substantially equal to the width W-LS in the one direction of the lower surface L-S1 of the separator SPR as a representative example.

In the embodiment, as the separator SPR may be disposed to be entirely in contact with an upper surface U-P of a pixel definition layer PDL, the upper surface U-S1 of the separator SPR may be entirely flat. The spacer SPC-1 may be covered by a first dummy layer UP1 above the upper surface U-S1 of the separator SPR.

According to the embodiment, a fine metal mask may be disposed on the spacer SPC-1 in a process of forming a light emitting layer EML. For example, the fine metal mask may be in contact with the upper surface U-C1 of the spacer SPC-1. The fine metal mask may not be in contact with the upper surface U-S1 of the separator SPR since the spacer SPC-1 may be disposed on the separator SPR. Accordingly, an area where the fine metal mask may be in contact with a component supporting the fine metal mask may be reduced. As a result, it may be possible to reduce a degree of damage to the spacer SPC-1 and the separator SPR caused by a dent defect of the fine metal mask. For example, a reliability of the spacer SPC-1 and the separator SPR may be improved after the light emitting layer EML is formed, and a first inorganic layer IL1 may be prevented from being defected. Thus, the process reliability may be improved, and defects in light emission of the display device DD (refer to FIG. 1) may be reduced or prevented.

According to the embodiment, the area where the fine metal mask may be in contact with the upper surface U-C1 of the spacer SPC-1 may be controlled by adjusting the number and/or area of the spacers SPC-1. For example, in the case that controlling the area of the upper surface U-C1 of the spacer SPC-1 that may be in contact with the fine metal mask to sufficiently support the fine metal mask and to minimize the damage of the spacer SPC-1 and the separator SPR, restrictions in controlling the area may be minimized.

The display panel DP-1 according to the embodiment may include the separator SPR through which division openings OP-S (refer to FIG. 4A) may be defined to provide cathodes EL2_1, EL2_2, andEL2_3 (refer to FIG. 4B) separated from each other for each pixel. Accordingly, the separator SPR may have a mesh shape surrounding each of light emitting parts EP1, EP2, and EP3 (refer to FIG. 4B), i.e., light emitting areas. According to the embodiment, as the spacer SPC-1 may be disposed on the upper surface US1 of the separator SPR, an additional space to place the spacer SPC-1 may not be required, and the size of the light emitting area may not be reduced even though the spacer SPC-1 may be provided.

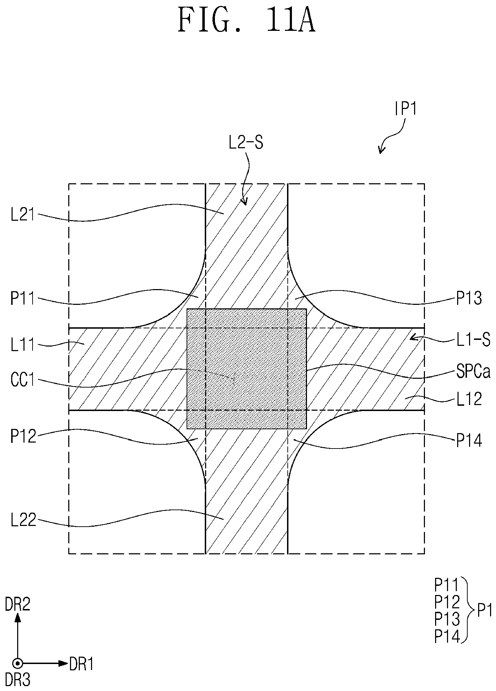

FIGS. 11A to 11C are enlarged plan views of an area of the display panel DP (refer to FIG. 1) according to embodiments of the disclosure. FIGS. 11A to 11C are enlarged plan views of the first intersecting portion IP1 of the separator SPR (refer to FIG. 8) and show shapes of spacers SPCa, SPCa1, and SPCa2 respectively overlapping the first intersecting portion IP1 in a planview. FIGS. 11A to 11C show the structure in which the spacers SPCa, SPCa1, and SPCa2 may be disposed on the separator SPR (refer to FIG. 8) as a representative example.

Referring to FIGS. 11A to 11C, the first intersecting portion IP1 may be defined as a cross-shaped portion where the first line L1-S and the second line L2-S of the separator SPR (refer to FIG. 8) intersect each other in a plan view.

The first intersecting portion IP1 may include a first intersecting area CC1, first-first and first-second line areas L11 and L12, second-first and second-second line areas L21 and L22, and first protruding areas P1.

The first intersecting area CC1 may be an area where the first line L1-S intersects the second line L2-S. The first-first line area L11 and the first-second line area L12 may extend in directions opposite to each other from the first intersecting area CC1 of the first line L1-S in the first direction DR1. The second-first line area L21 and the second-second line area L22 may extend in directions opposite to each other from the first intersecting area CC1 of the second line L2-S in the second direction DR2.

The first protruding areas P1 may protrude from corresponding line areas adjacent to each other among the first-first, first-second, second-first, and second-second line areas L11, L12, L21, and L22. The first protruding areas P1 may include first-first, first-second, first-third, and first-fourth protruding areas P11, P12, P13, and P14.

The first-first protruding area P11 may protrude from the first-first and second-first line areas L11 and L21. The first-first protruding area P11 may protrude from areas of the first-first and second-first line areas L11 and L21 adjacent to the first intersecting area CC1 toward an inner side of a division opening OP-S (refer to FIG. 8) defined by the first-first and second-first line areas L11 and L21. The first-second protruding area P12 may protrude from the first-first and second-second line areas L11 and L22. The first-second protruding area P12 may protrude from areas of the first-first and second-second line areas L11 and L22 adjacent to the first intersecting area CC1 toward an inner side of a division opening OP-S (refer to FIG. 8) defined by the first-first and second-second line areas L11 and L22.

The first-third protruding area P13 may protrude from the first-second and second-first line areas L12 and L21. The first-third protruding area P13 may protrude from areas of the first-second and second-first line areas L12 and L21 adjacent to the first intersecting area CC1 towards an inner side of a division opening OP-S (refer to FIG. 8) defined by the first-second and second-first line areas L12 and L21. The first-fourth protruding area P14 may protrude from the first-second and second-second line areas L12 and L22. The first-fourth protruding area P14 may protrude from areas of the first-second and second-second line areas L12 and L22 adjacent to the first intersecting area CC1 toward the inner side of the division opening OP-S (refer to FIG. 8) defined by the first-second and second-second line areas L12 and L22.

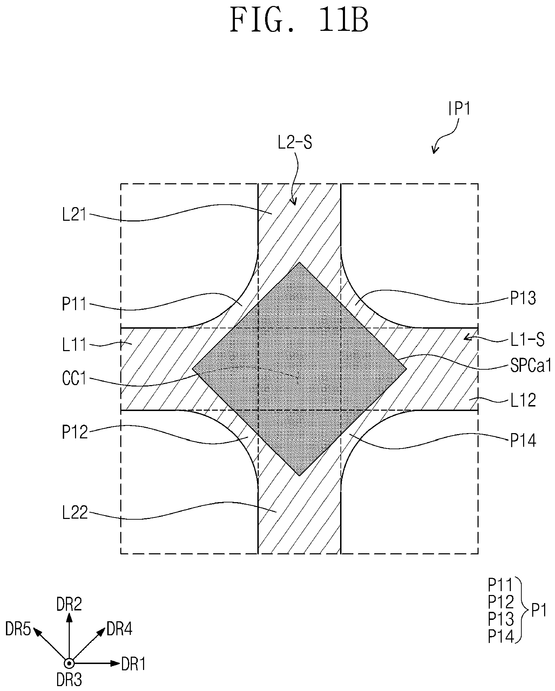

The spacers SPCa and SPCa1 overlapping the first intersecting portion IP1 may have a quadrangular shape as shown in FIGS. 11A and 11B.

As an example, the spacer SPCa overlapping the first intersecting portion IP1 may have a rectangular shape, e.g., a square shape, with sides extending in the first direction DR1 and sides extending in the second direction DR2, e.g., a square shape, as shown in FIG. 11A.

As an example, the spacer SPCa1 may have a quadrangular shape, e.g., a lozenge or rhombus shape, with sides extending in a fourth direction DR4 and sides extending in a fifth direction DR5 as shown in FIG. 11B. The fourth direction DR4 may be defined as a direction intersecting the first direction DR1 and the second direction DR2, and the fifth direction DR5 may be defined as a direction intersecting the fourth direction DR4. In FIG. 11B, the fifth direction DR5 may be defined as being perpendicular to the fourth direction DR4 as a representative example.

As shown in FIGS. 11A and 11B, the spacers SPCa and SPCa1 overlapping the first intersecting portion IP1 may overlap at least a portion of each of the first intersecting area CC1, the first-first, first-second, second-first, and second-second line areas L11, L12, L21, and L22, and the first protruding areas P1, however, the disclosure should not be limited thereto or thereby. According to an embodiment, the spacers SPCa and SPCa1 overlapping the first intersecting portion IP1 may be disposed not to overlap the first protruding areas P1 or may be disposed not to overlap the first-first, first-second, second-first, and second-second line areas L11, L12, L21, and L22.

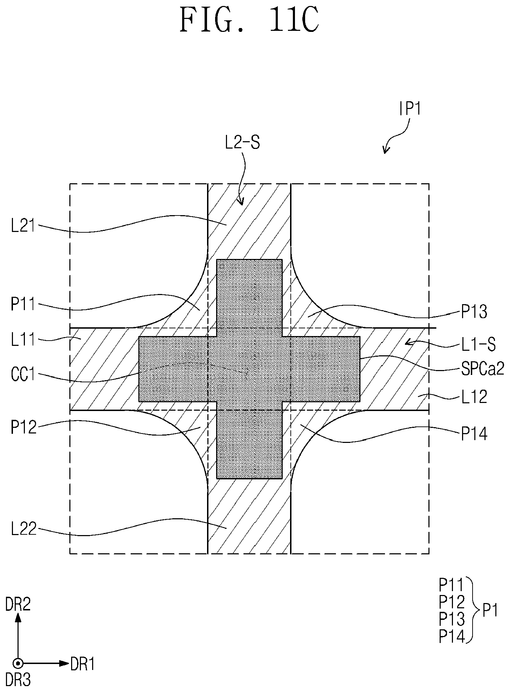

According to an embodiment, as shown in FIG. 11C, the spacer SPCa2 overlapping the first intersecting portion IP1 may have a cross shape defined by a portion extending in the first direction DR1 and a portion extending in the second direction DR2 and intersecting the portion extending in the first direction DR1. The portion extending in the first direction DR1 may overlap the first line L1-S, and the portion extending in the second direction DR2 may overlap the second line L2-S.

FIG. 11C shows a structure in which the spacer SPCa2 overlapping the first intersecting portion IP1 overlaps at least a portion of each of the first intersecting area CC1 and the first-first, first-second, second-first, and second-second line areas L11, L12, L21, and L22 and does not overlap the first protruding areas P1 as a representative example. However, the disclosure should not be limited thereto or thereby, and the spacer SPCa2 may be disposed to overlap the first protruding areas P1.

However, the shapes of the spacers SPCa, SPCa1, and SPCa2 each overlapping the first intersecting portion IP1 should not be particularly limited, and the spacers SPCa, SPCa1, and SPCa2 each overlapping the first intersecting portion IP1 may have a variety of shapes as long as the spacers SPCa, SPCa1, and SPCa2 may be disposed to overlap the first intersecting portion IP1.

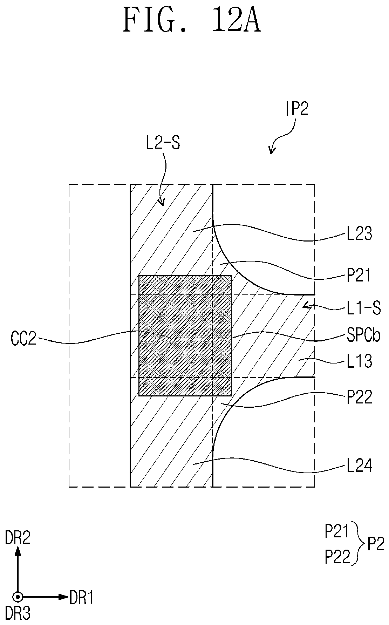

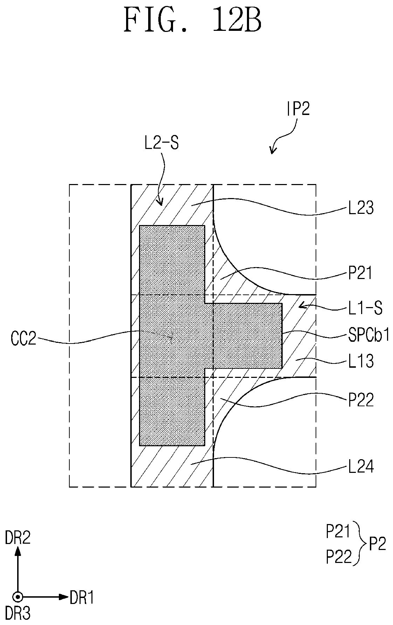

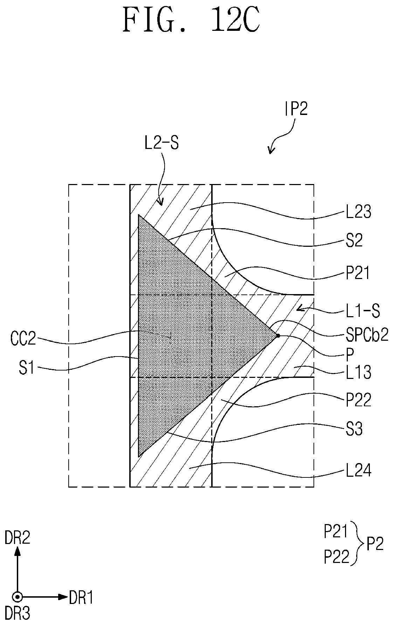

FIGS. 12A to 12C are enlarged plan views of an area of the display panel DP (refer to FIG. 1) according to embodiments of the disclosure. FIGS. 12A to 12C are enlarged plan views of the second intersecting portion IP2 of the separator SPR (refer to FIG. 8) and show shapes of spacers SPCb, SPCb1, and SPCb2 overlapping the second intersecting portion IP2 in a plan view. FIGS. 12Ato 12C show the structure in which the spacers SPCb, SPCb1, and SPCb2 may be disposed on the separator SPR (refer to FIG. 8) as a representative example.

Referring to FIG. 12B, the second intersecting portion IP2 may include the first line L1-S extending from one side of the second line L2-S of the separator SPR (refer to FIG. 8), and thus, the second intersecting portion IP2 may have a T-shape.

The second intersecting portion IP2 may include a second intersecting area CC2, a first-third line area L13, a second-third line area L23, a second-fourth line area L24, and second protruding areas P2.

The second intersecting area CC2 may be an area where the first line L1-S intersects the second line L2-S. The first-third line area L13 of the first line L1-S may extend from the second intersecting area CC2 to the first direction DR1. FIGS. 12A to 12C show the structure in which the first-third line area L13 extends from the second intersecting area CC2 to the first direction DR1 as a representative example, however, the first-third line area L13 may extend from the second intersecting area CC2 to a direction opposite to the first direction DR1 according to a position of the second intersecting portion IP2 in the separator SPR. The second-third line area L23 and the second-fourth line area L24 of the second line L2-S may extend from the second intersecting area CC2 to directions opposite to each other in the case that it is viewed in the second direction DR2.

The second protruding areas P2 may protrude from corresponding line areas adjacent to each other among the first-third, second-third, and second-fourth line areas L13, L23, and L24. The second protruding area P2 may include second-first and second-second protruding areas P21 and P22.

The second-first protruding area P21 may protrude from the first-third and second-third line areas L13 and L23. The second-first protruding area P21 may protrude from areas of the first-third and second-third line areas L13 and L23, which may be adjacent to the second intersecting area CC2, towards an inner side of a division opening OP-S (refer to FIG. 8) defined by the first-third and second-third line areas L13 and L23. The second-second protruding area P22 may protrude from the first-third and second-fourth line areas L13 and L24. The second-second protruding area P22 may extend from areas of the first-third and second-fourth line areas L13 and L24, which may be adjacent to the second intersecting area CC2, towards an inner side of a division opening OP-S (refer to FIG. 8) defined by the first-third and second-fourth line areas L13 and L24.

According to an embodiment, the spacer SPCb overlapping the second intersecting portion IP2 may have a quadrangular shape, e.g., a rectangular shape, defined by sides extending in the first direction DR1 and sides extending in the second direction DR2 as shown in FIG. 12A.

As shown in FIG. 12A, the spacer SPCb overlapping the second intersecting portion IP2 may overlap at least a portion of the second intersecting area CC2, the first-third, second-third, and second-fourth line areas L13, L23, and L24, and the second protruding areas P2. However, the disclosure should not be limited thereto or thereby. According to an embodiment, the spacer SPCb overlapping the second intersecting portion IP2 may be disposed not to overlap the second protruding areas P2 or may be disposed not to overlap the first-third, second-third, and second-fourth line areas L13, L23, and L24.

According to an embodiment, as shown in FIG. 12B, the spacer SPCb1 overlapping the second intersecting portion IP2 may have a T-shape defined by a portion extending in the second direction DR2 and a portion extending from the portion extending in the second direction DR2 to the first direction DR1. The portion extending in the first direction DR1 may overlap the first line L1-S, and the portion extending in the second direction DR2 may overlap the second line L2-S.

FIG. 12B shows the structure in which the spacer SPCb1 overlapping the second intersecting portion IP2 overlaps at least the portion of each of the second intersecting area CC2 and the first-third, second-third, and second-fourth line areas L13, L23, and L24 and does not overlap the second protruding areas P2, however, the disclosure should not be limited thereto or thereby. According to an embodiment, the spacer SPCb1 may be disposed to overlap the second protruding areas P2.

According to an embodiment, as shown in FIG. 12C, the spacer SPCb2 overlapping the second intersecting portion IP2 may have a triangular shape. The spacer SPCb2 overlapping the second intersecting portion IP2 may include first, second, and third sides S1, S2, and S3. The first side S1 may extend in the second direction DR2. In the embodiment, the first side S1 may overlap the second line L2-S. In addition, a vertex P where the second side S2 meets the third side S3 of the spacer SPCb2 may face the first side S1 and may overlap the first line L1-S. FIG. 12C shows the structure in which the spacer SPCb2 overlapping the second intersecting portion IP2 has an isosceles triangle shape in which the second side S2 and the third side S3 have the same length as a representative example, however, the disclosure should not be limited thereto or thereby.

As shown in FIG. 12C, the spacer SPCb2 overlapping the second intersecting portion IP2 may overlap at least a portion of the second intersecting area CC2, the first-third, second-third, and second-fourth line areas L13, L23, and L24, and the second protruding areas P2. However, according to an embodiment, the spacer SPCb2 overlapping the second intersecting portion IP2 may be disposed not to overlap the second protruding areas P2 or may also be disposed not to overlap the first-third, second-third, and second-fourth line areas L13, L23, and L24.

However, the shapes of the spacers SPCb, SPCb1, and SPCb2 each overlapping the second intersecting portion IP2 should not be particularly limited, and the spacers SPCb, SPCb1, and SPCb2 each overlapping the second intersecting portion IP2 may have a variety of shapes as long as the spacers SPCb, SPCb1, and SPCb2 may be disposed to overlap the second intersecting portion IP2.

Referring to FIGS. 8 and 11A to 12C, the first line L1-S and the second line L2-S may intersect in a rounded shape without intersecting vertically in the intersecting portion IP due to etching deviation. As an example, the first protruding areas P1 and the second protruding areas P2 may correspond to portions of the separator SPR around corners remaining without being etched during the process of etching the separator SPR to form the division opening OP-S.

According to the embodiment, in the case that the spacer SPC may be disposed to overlap the intersecting portion IP, the spacer SPC may be disposed to overlap the first protruding areas P1 or the second protruding areas P2. Particularly, in the case of placing the spacer SPC under the separator SPR, the area where the separator SPR may be supported may be greater than another area. Therefore, in the case where the spacer SPC overlaps the intersecting portion IP, the spacer SPC may more stably support the separator SPR.

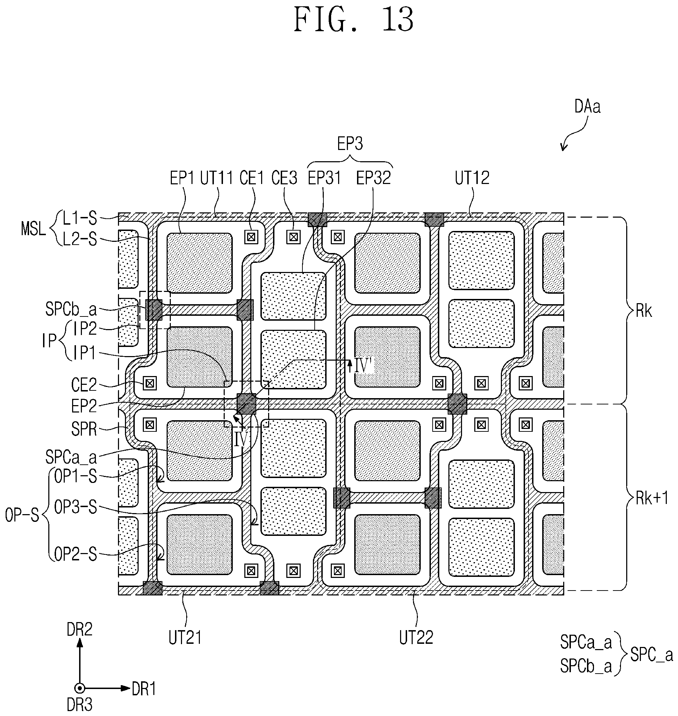

FIG. 13 is an enlarged plan view of an area of the display panel DP (refer to FIG. 1) according to an embodiment of the disclosure. FIG. 13 is a plan view corresponding to that of FIG. 4A. FIG. 13 shows a portion of a display area DAa corresponding to that of FIG. 4A. For the convenience of explanation, FIG. 13 shows only a separator SPR, spacers SPC_a, light emitting parts EP1, EP2, and EP3, and light emitting connection parts CE1, CE2, and CE3 among components of the display panel DP (refer to FIG. 1).

Referring to FIG. 13, a portion of each of the spacers SPC_a may be disposed to overlap the separator SPR in a plan view. Only the portion of each of the spacers SPC_a may overlap the separator SPR in a plan view. In other words, another portion of each of the spacers SPC_a may be exposed without being covered by the separator SPR.

In the embodiment, each of the spacers SPC_a may overlap one of intersecting portions IP of the separator SPR. In more detail, some spacers SPCa_a of the spacers SPC_a may overlap first intersecting portions IP1, and another spacers SPCb_a of the spacers SPC_a may overlap second intersecting portions IP2.

In the embodiment, the spacers SPC_a may be disposed to overlap only some intersecting portions of the intersecting portions IP of the separator SPR. The spacers SPC_a may overlap the some intersecting portions, respectively. However, the number and positions of the spacers SPC_a should not be limited to those shown in FIG. 13.

Each of the spacers SPCa_a overlapping the first intersecting portion IP1 may have a quadrangular shape or a cross shape. The quadrangular shape may correspond to the quadrangular shape including the sides extending in the first direction DR1 and the sides extending in the second direction DR2 as described with reference to FIG. 11A or may correspond to the quadrangular shape including the sides extending in the fourth direction DR4 (refer to FIG. 11B) and the sides extending in the fifth direction DR5 (refer to FIG. 11B) as described with reference to FIG. 11B. The cross shape may correspond to the shape defined by the portion extending in the first direction DR1 and the portion extending in the second direction DR2 intersecting the portion extending in the first direction DR1 as shown in FIG. 11C.

For example, the shape of the spacers SPCa_a disposed to overlap the first intersecting portion IP1 in FIG. 13 may be similar to the shape of the spacers SPCa, SPCa1, and SPCa2 shown in FIG. 11A to 11C, and the only difference between the spacers SPCa_a of FIG. 13 and the spacers SPCa, SPCa1, and SPCa2 of FIGS. 11A to 11C may be that the size of the spacers SPCa_a may be increased to allow the spacers SPCa_a to be exposed without being covered by the separator SPR in a plan view.

Each of the spacers SPCb_a overlapping the second intersecting portion IP2 may have a quadrangular shape, a T-shape, or a triangular shape. The quadrangular shape may correspond to the shape defined by the sides extending in the first direction DR1 and the sides extending in the second direction DR2 as shown in FIG. 12A. The T-shape may correspond to the shape defined by the portion extending in the second direction DR2 and the portion extending in the first direction DR1 as shown in FIG. 12B. The triangular shape may correspond to the shape in which the first side S1 (refer to FIG. 12C) extends in the second direction DR2 and the vertex P (refer to FIG. 12C) where the second side S2 (refer to FIG. 12C) meets the third side S3 (refer to FIG. 12C) overlaps the first line L1-S as shown in FIG. 12C.

For example, the shape of the spacers SPCb_a overlapping the second intersecting portion IP2 of FIG. 13 may be similar to the shape of the spacers SPCb, SPCb1, and SPCb2 of FIG. 12A to 12C, and the only difference between the spacers SPCb_a of FIG. 13 and the spacers SPCb, SPCb1, and SPCb2 of FIGS. 12A to 12C may be that the size of the spacers SPCb_a may be increased to allow the spacers SPCb_a to be exposed without being covered by the separator SPR in a plan view. In the case where the spacers SPCb_a have the triangular shape, different from FIG. 12C, the first side S1 (refer to FIG. 12C) may be disposed outside the second line L2-S.

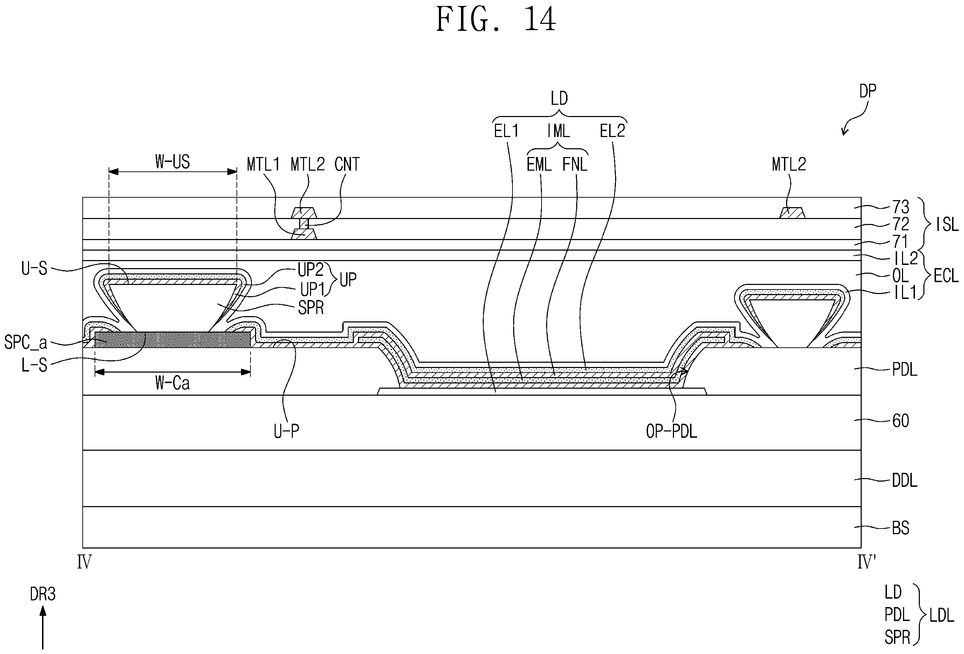

FIG. 14 is an enlarged schematic cross-sectional view of an area of a display panel DP taken along line IV-IV' of FIG. 13 according to an embodiment of the disclosure. In FIG. 14, the same/similar reference numerals denote the same/similar elements in FIGS. 5 to 9B, and thus, detailed descriptions the same/similar elements will be omitted.

Referring to FIG. 14, the spacer SPC_a may be disposed between a pixel definition layer PDL and the separator SPR. For example, the spacer SPC_a may be disposed (e.g., directly disposed) on an upper surface U-P of the pixel definition layer PDL and may be disposed under the separator SPR.

In a cross-sectional view, a width W-Ca in one direction of the spacer SPC_a may be greater than a width W-US in the one direction of an upper surface U-S of the separator SPR. Accordingly, a portion of the spacer SPC_a may be exposed without being covered by the separator SPR in a plan view. According to the embodiment where the width W-Ca of the spacer SPC_a may be greater than the width W-US of the separator SPR, the spacer SPC_a may not be disposed on the separator SPR and may be disposed only under the separator SPR.

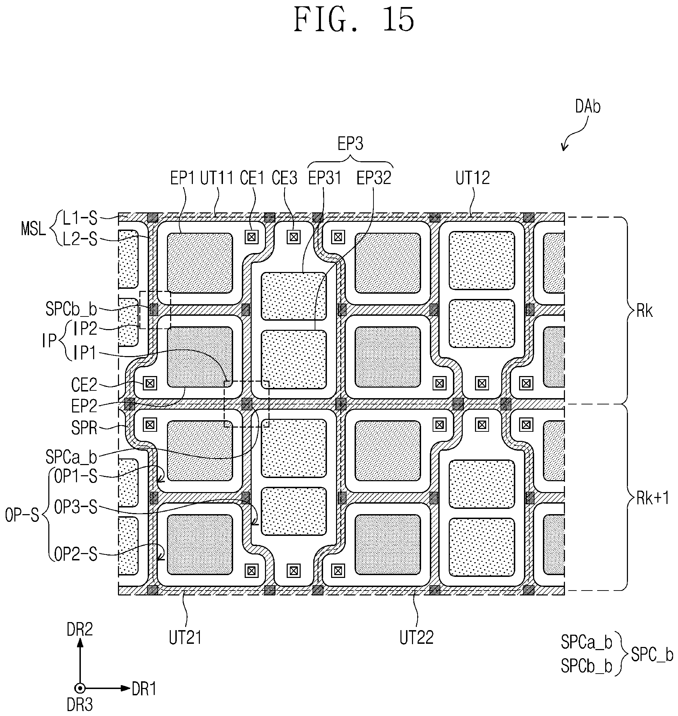

FIG. 15 is an enlarged plan view of an area of a display panel according to an embodiment of the disclosure. FIG. 15 is a plan view of a portion corresponding to that of FIG. 4A. FIG. 15 shows a portion of a display area DAb corresponding to that of FIG. 4A. For the convenience of explanation, FIG. 15 shows only a separator SPR, spacers SPC_b, light emitting parts EP1, EP2, and EP3, and light emitting connection parts CE1, CE2, and CE3 among components of the display panel DP (refer to FIG. 1).

Referring to FIG. 15, the spacers SPC_b may respectively overlap intersecting portions IP of the separator SPR. The spacers SPC_b may be disposed to overlap the intersecting portions IP of the separator SPR, and each of the spacers SPC_b may overlap a corresponding intersecting portion among the intersecting portions IP. For example, each of the intersecting portions IP may overlap one spacer SPC_b in a plan view.

The intersecting portions IP of the separator SPR may include first intersecting portions IP1 having a cross shape and second intersecting portions IP2 having a T-shape. Some spacers SPCa_b among the spacers SPC_b may respectively overlap the first intersecting portions IP1, and the other spacers SPCb_b among the spacers SPC_b may respectively overlap the second intersecting portions IP2. For example, each of the first intersecting portions IP1 and the second intersecting portions IP2 may overlap a corresponding spacer among the spacers SPC_b.

FIG. 15 shows the structure in which an entire area of each of the spacers SPC_b overlaps the separator SPR in a plan view as a representative example, however, the disclosure should not be limited thereto or thereby. For example, a portion of the spacers SPC_b may be exposed without being covered by the separator SPR in a plan view as described with reference to FIG. 13.

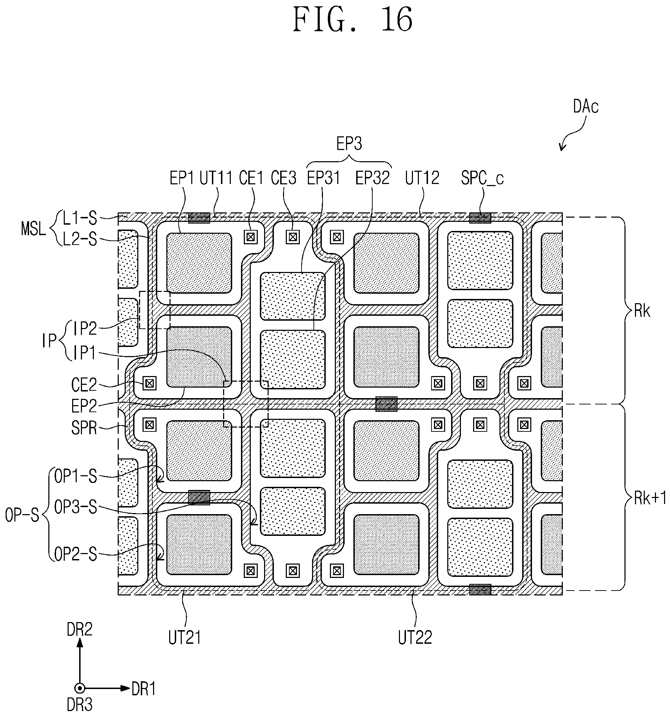

FIG. 16 is an enlarged plan view of an area of a display panel according to an embodiment of the disclosure. FIG. 16 is a plan view of a portion corresponding to that of FIG. 4A. FIG. 16 shows a portion of a display area Dac corresponding to that of FIG. 4A. For the convenience of explanation, FIG. 16 shows only a separator SPR, spacers SPC_c, light emitting parts EP1, EP2, and EP3, and light emitting connection parts CE1, CE2, and CE3 among components of the display panel DP (refer to FIG. 1).

Referring to FIG. 16, each of the spacers SPC_c may be disposed to overlap at least one of first lines L1-S and second lines L2-S. The spacers SPC_c may not overlap intersecting portions IP.

FIG. 16 shows the structure in which the spacers SPC_c overlap only the first lines L1-S as a representative example, however, the disclosure should not be limited thereto or thereby. According to an embodiment, the spacers SPC_c may overlap only the second lines L2-S. According to an embodiment, some spacers of the spacers SPC_c may overlap the first lines L1-S, and the other spacers of the spacers SPC_c may overlap the second lines L2-S. In addition, the number and positions of the spacers SPC_c should not be limited to those of FIG. 16.

FIG. 16 shows the structure in which a portion of each of the spacers SPC_c may be exposed without being covered by the separator SPR in a plan view as a representative example, however, the disclosure should not be limited thereto or thereby. For example, as described with reference to FIG. 8, an entire area of each of the spacers SPC_c may be disposed to overlap the separator SPR in a plan view.

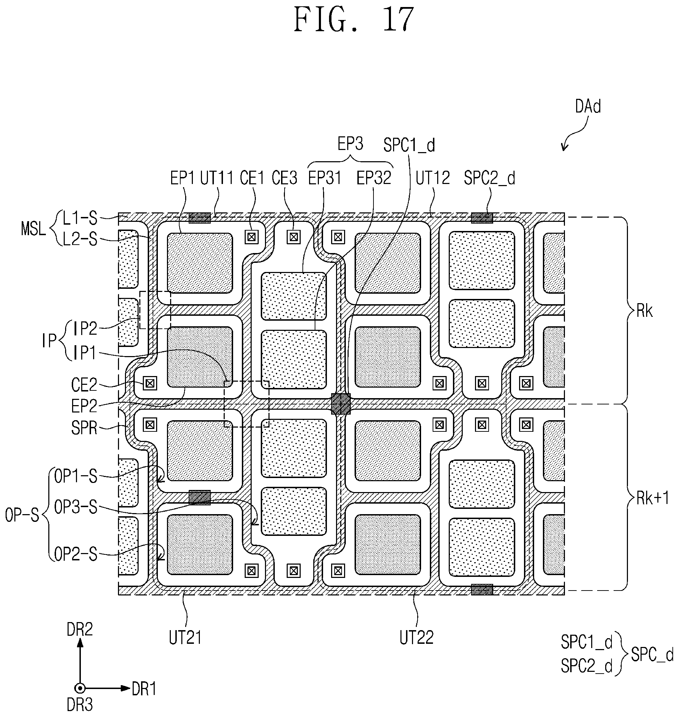

FIG. 17 is an enlarged plan view of an area of a display panel according to an embodiment of the disclosure. FIG. 17 is a plan view of a portion corresponding to that of FIG. 4A. FIG. 17 shows a portion of a display area DAd corresponding to that of FIG. 4A. For the convenience of explanation, FIG. 17 shows only a separator SPR, spacers SPC_d, light emitting parts EP1, EP2, and EP3, and light emitting connection parts CE1, CE2, and CE3 among components of the display panel DP (refer to FIG. 1).

Referring to FIG. 17, the spacers SPC_d may include a first spacer SPC1_d and a second spacer SPC2_d.

The first spacer SPC1_d may overlap one of intersecting portions IP. FIG. 17 shows the structure in which one first spacer SPC1_d overlaps first intersecting portion IP1 as a representative example, however, the first spacer SPC1_d may overlap second intersecting portion IP2. In addition, the number and positions of the first spacers SPC1_d should not be limited to the embodiment shown in FIG. 17.

The second spacer SPC2_d may be disposed to overlap one of first lines L1-S and second lines L2-S. FIG. 17 shows the structure in which multiple second spacers SPC2_d may be disposed to overlap only the first lines L1-S as a representative example. However, according to an embodiment, the second spacers SPC2_d may overlap only the second lines L2-S, or some spacer of the second spacers SPC2_d may overlap the first lines L1-S and the other spacer of the second spacers SPC2_d may overlap the second lines L2-S. In addition, the number and positions of the second spacers SPC2_d should not be limited to the embodiment of FIG. 17.

FIG. 17 shows the structure in which a portion of each of the spacers SPC_d may be exposed without being covered by the separator SPR in a plan view as a representative example, however, the disclosure should not be limited thereto or thereby. For example, an entire area of each of the spacers SPC_d may overlap the separator SPR in a plan view as described with reference to FIG. 8.

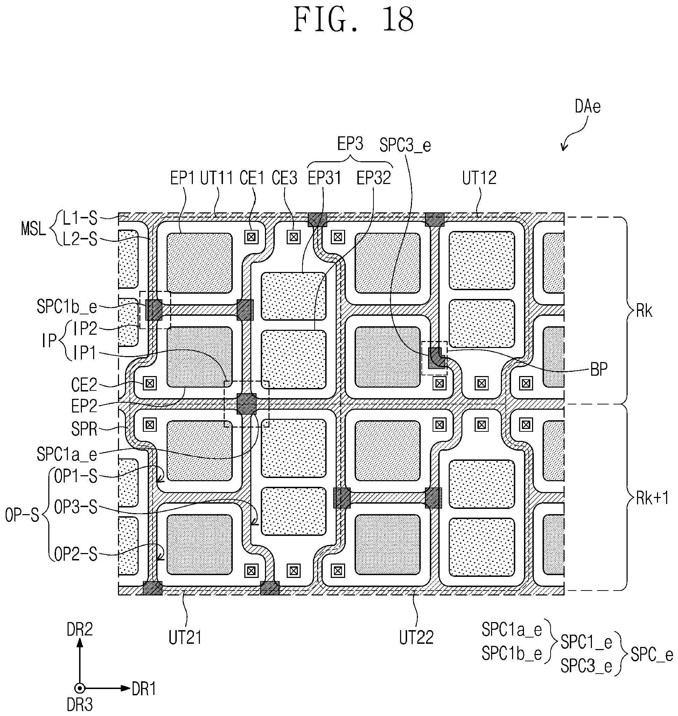

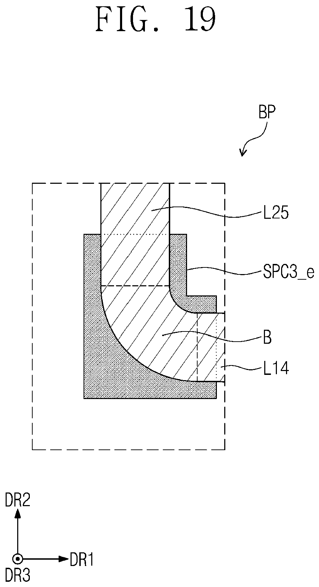

FIG. 18 is an enlarged plan view of an area of a display panel according to an embodiment of the disclosure. FIG. 19 is an enlarged plan view of an area of a display panel according to an embodiment of the disclosure. FIG. 18 is a plan view of a portion corresponding to that of FIG. 4A. FIG. 18 shows a portion of a display area DAe corresponding to that of FIG. 4A. For the convenience of explanation, FIG. 18 shows only a separator SPR, spacers SPC_e, light emitting parts EP1, EP2, and EP3, and light emitting connection parts CE1, CE2, and CE3 among components of the display panel DP (refer to FIG. 1).

Referring to FIG. 18, the spacers SPC_e may include a first spacer SPC1_e and a third spacer SPC3_e.

The first spacer SPC1_e may overlap one of intersecting portions IP. FIG. 18 shows the structure in which some first spacers SPC1a_e of the first spacers SPC1_e overlap first intersecting portions IP1 and the other first spacers SPC1b_e of the first spacers SPC1_e overlap second intersecting portions IP2 as a representative example, however, the disclosure should not be limited thereto or thereby. According to an embodiment, the first spacers SPC1_e may overlap only the first intersecting portions IP1 or only the second intersecting portions IP2. In addition, the number and positions of the first spacers SPC1_e should not be limited to the embodiment of FIG. 18.

The third spacer SPC3_e may overlap a bending portion BP of the separator SPR. In the embodiment, the bending portion BP may be defined in the separator SPR. According to the embodiment, a first line L1-S and a second line L2-S may be extended to each other in a rounded shape without being vertically extended to each other due to etching deviation, and thus, the bending portion BP may be defined in the separator SPR.

FIG. 19 is an enlarged plan view of the bending portion BP of the separator SPR and shows the third spacer SPC3_e overlapping the bending portion BP. FIG. 19 shows the structure in which the third spacer SPC3_e may be disposed under the separator SPR (refer to FIG. 8) as a representative example. Referring to FIGS. 18 and 19, the bending portion BP may include a bending area B, a first-fourth line area L14 of the first lines L1-S, which extends from the bending area B in a direction parallel to the first direction DR1, and a second-fifth line area L25 of the second lines L2-S, which extends from the bending area B in a direction parallel to the second direction DR2.

According to the embodiment, the third spacer SPC3_e overlapping the bending portion BP may have an L-shape. The third spacer SPC3_e may include a portion extending in the first direction DR1 and a portion extending in the second direction DR2. The portion extending in the first direction DR1 may overlap the first-fourth line area L14 and the bending area B, and the portion extending in the second direction DR2 may overlap the second-fifth line area L25 and the bending area B. However, the shape of the third spacer SPC3_e should not be particularly limited, and the third spacer SPC3_e may have a variety of shapes as long as the third spacer SPC3_e overlaps the bending portion BP.

FIG. 18 shows only one third spacer SPC3_e, however, the number and positions of the third spacers SPC3_e should not be limited to the embodiment shown in FIG. 18.

FIG. 18 shows the structure in which a portion of each of the spacers SPC_e may be exposed without being covered by the separator SPR in a plan view as a representative example, and an entire area of each of the spacers SPC_e may overlap the separator SPR in a plan view as shown in FIG. 8.

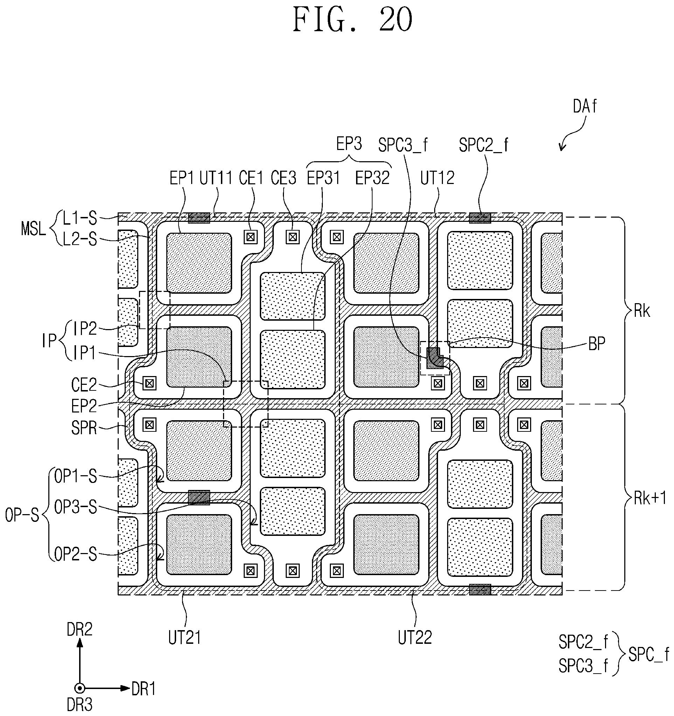

FIG. 20 is an enlarged plan view of an area of a display panel according to an embodiment of the disclosure. FIG. 20 is a plan view of a portion corresponding to that of FIG. 4A. FIG. 20 shows a portion of a display area DAf corresponding to that of FIG. 4A. For the convenience of explanation, FIG. 20 shows only a separator SPR, spacers SPC_f, light emitting parts EP1, EP2, and EP3, and light emitting connection parts CE1, CE2, and CE3 among components of the display panel DP (refer to FIG. 1).

Referring to FIG. 20, the spacers SPC_f may include a second spacer SPC2_f and a third spacer SPC3_f.

The second spacer SPC2_f may be disposed to overlap one of first lines L1-S and second lines L2-S. FIG. 20 shows the structure in which multiple second spacers SPC2_f may be disposed to overlap only the first lines L1-S as a representative example, however, the second spacers SPC2_f may overlap only the second lines L2-S. According to an embodiment, some second spacers of the second spacers SPC2_f may overlap the first lines L1-S, and the other second spacers of the second spacers SPC2_f may overlap the second lines L2-S. In addition, the number and positions of the second spacers SPC2_f should not be limited to the embodiment of FIG. 20.

The third spacer SPC3_f may overlap the bending portion BP of the separator SPR. FIG. 20 shows only one third spacer SPC3_f, however, the number and positions of the third spacers SPC3_f should not be limited to the embodiment shown in FIG. 20.

FIG. 20 shows the structure in which a portion of each of the spacers SPC_f may be exposed without being covered by the separator SPR in a plan view as a representative example, however, the disclosure should not be limited thereto or thereby. For example, an entire area of each of the spacers SPC_f may overlap the separator SPR in a plan view as shown in FIG. 8.

Although the embodiments of the disclosure have been described, it is understood that the disclosure should not be limited to these embodiments but various changes and modifications can be made by one ordinary skilled in the art within the scope of the disclosure as hereinafter claimed. Therefore, the disclosed subject matter should not be limited to any single embodiment described herein, and the scope of the inventive concept shall be determined according to the attached claims.

Embodiments are set out in the following clauses:
1. A display device comprising:
   a plurality of light emitting devices each comprising a first electrode, a second electrode, and an intermediate layer disposed between the first electrode and the second electrode and comprising a light emitting layer;
   a pixel definition layer comprising a plurality of light emitting openings, wherein each of the plurality of light emitting openings overlaps the light emitting layer of a corresponding one of the plurality of light emitting devices;
   a separator disposed on the pixel definition layer and comprising a plurality of division openings, wherein each of the plurality of division openings overlaps a corresponding one of the plurality of light emitting openings; and
   at least one spacer disposed on the pixel definition layer, wherein
   the second electrode of each of the plurality of light emitting devices overlaps a corresponding one of the plurality of division openings and is electrically separated from each other by the separator, and
   the at least one spacer overlaps a portion of the separator in a plan view.
Clause 2. The display device of clause 1, wherein the at least one spacer is disposed between the pixel definition layer and the separator.
Clause 3. The display device of clause 2, wherein an entire area of the at least one spacer overlaps the separator in a plan view.
Clause 4. The display device of clause 2, wherein the at least one spacer is partially exposed without being covered by the separator in a plan view.
Clause 5. The display device of any one of clauses 2 to 4, wherein
   the separator comprises a lower surface adjacent to the pixel definition layer and an upper surface opposite to the lower surface and having a width greater than a width of the lower surface in a cross-sectional view, and
   the at least one spacer has a width equal to or greater than the width of the lower surface of the separator in a cross-sectional view.
Clause 6. The display device of any one of clauses 2 to 4, wherein
   the separator comprises a lower surface adjacent to the pixel definition layer and an upper surface opposite to the lower surface, and
   a distance between the pixel definition layer and a portion of the upper surface of the separator that overlaps the at least one spacer is greater than a distance between the pixel definition layer and a portion of the upper surface of the separator that does not overlap the at least one spacer.
Clause 7. The display device of clause 1, wherein
   the at least one spacer is disposed on the separator, and
   an entire area of the at least one spacer overlaps the separator in a plan view.
Clause 8. The display device of clause 7, wherein
   the separator comprises a lower surface adjacent to the pixel definition layer and an upper surface opposite to the lower surface, the upper surface having a width greater than a width of the lower surface in a cross-sectional view, and
   the at least one spacer has a width equal to or smaller than a width of the upper surface of the separator in a cross-sectional view.
Clause 9. The display device of any one of clauses 1 to 8, wherein
   the separator comprises a division mesh line defining the plurality of division openings, the division mesh line comprising a plurality of first lines extending in a first direction and a plurality of second lines extending in a second direction, and
   the separator comprises a plurality of intersecting portions where ones of the plurality of first lines intersect ones of the plurality of second lines.
Clause 10. The display device of clause 9, wherein the at least one spacer overlaps one of the plurality of intersecting portions.
Clause 11. The display device of clause 9 or clause 10, wherein the plurality of intersecting portions comprise:
   at least one first intersecting portion having a cross shape in a plan view; and
   at least one second intersecting portion having a T-shape in a plan view.
Clause 12. The display device of clause 11, wherein
   the at least one spacer overlaps the at least one first intersecting portion, and
   the at least one spacer has a quadrangular shape or a cross shape in a plan view.
Clause 13. The display device of clause 11 or clause 12, wherein the at least one first intersecting portion comprises:
   a first intersecting area;
   first-first and first-second line areas of each of the plurality of first lines extending from the first intersecting area to directions opposite to each other in the first direction;
   second-first and second-second line areas of each of the plurality of second lines extending from the first intersecting area to directions opposite to each other in the second direction; and
   first protruding areas protruding from corresponding line areas adjacent to each other among the first-first, first-second, second-first, and second-second line areas, wherein the at least one spacer overlaps at least a portion of each of the first intersecting area, the first-first and first-second line areas, the second-first and second-second line areas, and the first protruding areas.
Clause 14. The display device of any one of clauses 11 to 13, wherein
   the at least one spacer overlaps the at least one second intersecting portion, and
   the at least one spacer has a quadrangular shape, a T-shape, or a triangular shape in a plan view.
Clause 15. The display device of any one of clauses 11 to 14, wherein
   the at least one second intersecting portion comprises:
      a second intersecting area;
      a first-third line area of each of the plurality of first lines extending from the second intersecting area in the first direction;
      second-third and second-fourth line areas of each of the plurality of second lines extending from the second intersecting area to directions opposite to each other in the second direction; and
      second protruding areas protruding from corresponding line areas adjacent to each other among the first-third, second-third, and second-fourth line areas, and
   the at least one spacer overlaps at least a portion of each of the second intersecting area, the first-third line area, the second-third and second-fourth line areas, and the second protruding areas.
Clause 16. The display device of any one of clauses 11 to 15, wherein
   the at least one first intersecting portion includes a plurality of first intersecting portions,
   the at least one second intersecting portion includes a plurality of second intersecting portions,
   the at least one spacer includes a plurality of spacers, and
   each of the plurality of first intersecting portions and the plurality of second intersecting portions overlap a corresponding one of the plurality of spacers.
Clause 17. The display device of any one of clauses 11 to 15, wherein
   the at least one first intersecting portion includes a plurality of first intersecting portions
   the at least one second intersecting portion includes a plurality of second intersecting portions,
   the at least one spacer includes a plurality of spacers,
   some of the plurality of first intersecting portions and some of the plurality of second intersecting portions overlap a corresponding one of the plurality of spacers, and
   others of the plurality of first intersecting portions and others of the plurality of second intersecting portions do not overlap any of the plurality of spacers.
Clause 18. The display device of clause 9, wherein
   the at least one spacer includes a plurality of spacers,
   the plurality of spacers comprise a first spacer and a second spacer,
   the first spacer overlaps one of the plurality of intersecting portions, and
   the second spacer is spaced apart from each of the plurality of intersecting portions and overlaps one of the plurality of first lines and the plurality of second lines.
Clause 19. The display device of clause 9, wherein
   the separator further comprises a bending portion, and
   the bending portion comprises:
      a bending area;
      a first-fourth line area of each of the plurality of first lines extending from the bending area in the first direction; and
      a second-fifth line area of each the plurality of second lines extending from the bending area in the second direction.
Clause 20. The display device of clause 19, wherein the at least one spacer overlaps the bending portion in a plan view.
Clause 21. The display device of clause 20, wherein the at least one spacer overlapping the bending portion has an L-shape.
Clause 22. The display device of any one of clauses 19 to 21, wherein
   the at least one spacer includes a plurality of spacers,
   the plurality of spacers comprise a first spacer and a second spacer,
   the first spacer overlaps one of the plurality of intersecting portions, and
   the second spacer is spaced apart from each of the plurality of intersecting portions and overlaps the bending portion.
Clause 23. The display device of any one of clauses 19 to 21, wherein
   the at least one spacer includes a plurality of spacers,
   the plurality of spacers comprise a first spacer and a second spacer,
   the first spacer is spaced apart from the plurality of intersecting portions and overlaps one of the plurality of first lines and the plurality of second lines, and
   the second spacer is spaced apart from the plurality of intersecting portions and overlaps the bending portion.
Clause 24. The display device of clause 9, wherein
   the at least one spacer includes a plurality of spacers, and
   each of the plurality of spacers is spaced apart from each of the plurality of intersecting portions and overlaps one of the plurality of first lines and the plurality of second lines.
Clause 25. The display device of any one of clauses 1 to 24, wherein the at least one spacer comprises an organic material.
Clause 26. The display device of clause 25, wherein the organic material comprises polyimide.
Clause 27. The display device of any one of clauses 1 to 26, further comprising:
   a first dummy layer disposed on the separator and spaced apart from the intermediate layer of each of the plurality of light emitting devices, the first dummy layer and the intermediate layer of each of the light emitting devices including a same material; and
   a second dummy layer disposed on the first dummy layer and spaced apart from the second electrode of each of the plurality of light emitting devices, the second dummy layer and the second electrode of each of the plurality of light emitting devices including a same material.
Clause 28. The display device of any one of clauses 1 to 27, further comprising:
   a plurality of transistors, each of the plurality of transistors is electrically connected to the second electrode of a corresponding one of the plurality of light emitting devices and
   a plurality of connection wirings, each of the plurality of connection wirings electrically connecting a corresponding one of the plurality of transistors to the second electrode of a corresponding one of the plurality of light emitting devices
   wherein each of the plurality of connection wirings comprises:
      a light emitting connection part electrically connected to a corresponding second electrode of one of the plurality of light-emitting devices and spaced apart from a corresponding one of the plurality of light emitting openings; and
      a driver connection part electrically connected to a corresponding transistor among the plurality of transistors.

## Claims

1. A display device comprising:
a plurality of light emitting devices each comprising a first electrode, a second electrode, and an intermediate layer disposed between the first electrode and the second electrode and comprising a light emitting layer;
a pixel definition layer comprising a plurality of light emitting openings, wherein each of the plurality of light emitting openings overlaps the light emitting layer of a corresponding one of the plurality of light emitting devices;
a separator disposed on the pixel definition layer and comprising a plurality of division openings, wherein each of the plurality of division openings overlaps a corresponding one of the plurality of light emitting openings; and
at least one spacer disposed on the pixel definition layer, wherein
the second electrode of each of the plurality of light emitting devices overlaps a corresponding one of the plurality of division openings and a plurality of second electrodes of the plurality of light emitting devices are electrically separated from each other by the separator, and
the at least one spacer overlaps a portion of the separator in a plan view.

2. The display device of claim 1, wherein the at least one spacer is disposed between the pixel definition layer and the separator.

3. The display device of claim 2, wherein:
(i) an entire area of the at least one spacer overlaps the separator in a plan view; or
(ii) the at least one spacer is partially exposed without being covered by the separator in a plan view.

4. The display device of claim 2 or claim 3, wherein:
(i) the separator comprises a lower surface adjacent to the pixel definition layer and an upper surface opposite to the lower surface and having a width greater than a width of the lower surface in a cross-sectional view, and
the at least one spacer has a width equal to or greater than the width of the lower surface of the separator in a cross-sectional view; or
(ii) the separator comprises a lower surface adjacent to the pixel definition layer and an upper surface opposite to the lower surface, and
a distance between the pixel definition layer and a portion of the upper surface of the separator that overlaps the at least one spacer is greater than a distance between the pixel definition layer and a portion of the upper surface of the separator that does not overlap the at least one spacer.

5. The display device of claim 1, wherein
the at least one spacer is disposed on the separator, and
an entire area of the at least one spacer overlaps the separator in a plan view, optionally wherein
the separator comprises a lower surface adjacent to the pixel definition layer and an upper surface opposite to the lower surface, the upper surface having a width greater than a width of the lower surface in a cross-sectional view, and
the at least one spacer has a width equal to or smaller than a width of the upper surface of the separator in a cross-sectional view.

6. The display device of any one of claims 1 to 5, wherein
the separator comprises a division mesh line defining the plurality of division openings, the division mesh line comprising a plurality of first lines extending in a first direction and a plurality of second lines extending in a second direction, and
the separator comprises a plurality of intersecting portions where ones of the plurality of first lines intersect ones of the plurality of second lines.

7. The display device of claim 6, wherein the at least one spacer overlaps one of the plurality of intersecting portions.

8. The display device of claim 6, wherein the plurality of intersecting portions comprise:
at least one first intersecting portion having a cross shape in a plan view; and
at least one second intersecting portion having a T-shape in a plan view, optionally wherein
the at least one spacer overlaps the at least one first intersecting portion, and
the at least one spacer has a quadrangular shape or a cross shape in a plan view.

9. The display device of claim 8, wherein:
(i) the at least one first intersecting portion comprises:
a first intersecting area;
first-first and first-second line areas of each of the plurality of first lines extending from the first intersecting area to directions opposite to each other in the first direction;
second-first and second-second line areas of each of the plurality of second lines extending from the first intersecting area to directions opposite to each other in the second direction; and
first protruding areas protruding from corresponding line areas adjacent to each other among the first-first, first-second, second-first, and second-second line areas, wherein the at least one spacer overlaps at least a portion of each of the first intersecting area, the first-first and first-second line areas, the second-first and second-second line areas, and the first protruding areas; and/or
(ii) the at least one spacer overlaps the at least one second intersecting portion, and the at least one spacer has a quadrangular shape, a T-shape, or a triangular shape in a plan view; and/or
(iii) the at least one second intersecting portion comprises:
a second intersecting area;
a first-third line area of each of the plurality of first lines extending from the second intersecting area in the first direction;
second-third and second-fourth line areas of each of the plurality of second lines extending from the second intersecting area to directions opposite to each other in the second direction; and
second protruding areas protruding from corresponding line areas adjacent to each other among the first-third, second-third, and second-fourth line areas, and
the at least one spacer overlaps at least a portion of each of the second intersecting area, the first-third line area, the second-third and second-fourth line areas, and the second protruding areas.

10. The display device of claim 8 or claim 9, wherein:
(i) the at least one first intersecting portion includes a plurality of first intersecting portions,
the at least one second intersecting portion includes a plurality of second intersecting portions,
the at least one spacer includes a plurality of spacers, and
each of the plurality of first intersecting portions and the plurality of second intersecting portions overlap a corresponding one of the plurality of spacers; or
(ii) the at least one first intersecting portion includes a plurality of first intersecting portions
the at least one second intersecting portion includes a plurality of second intersecting portions,
the at least one spacer includes a plurality of spacers,
some of the plurality of first intersecting portions and some of the plurality of second intersecting portions overlap a corresponding one of the plurality of spacers, and
others of the plurality of first intersecting portions and others of the plurality of second intersecting portions do not overlap any of the plurality of spacers.

11. The display device of claim 6, wherein
the at least one spacer includes a plurality of spacers,
the plurality of spacers comprise a first spacer and a second spacer,
the first spacer overlaps one of the plurality of intersecting portions, and
the second spacer is spaced apart from each of the plurality of intersecting portions and overlaps one of the plurality of first lines and the plurality of second lines.

12. The display device of claim 6, wherein
the separator further comprises a bending portion, and
the bending portion comprises:
a bending area;
a first-fourth line area of each of the plurality of first lines extending from the bending area in the first direction; and
a second-fifth line area of each the plurality of second lines extending from the bending area in the second direction.

13. The display device of claim 12, wherein the at least one spacer overlaps the bending portion in a plan view, optionally wherein the at least one spacer overlapping the bending portion has an L-shape.

14. The display device of claim 12 or claim 13, wherein:
(i) the at least one spacer includes a plurality of spacers,
the plurality of spacers comprise a first spacer and a second spacer,
the first spacer overlaps one of the plurality of intersecting portions, and
the second spacer is spaced apart from each of the plurality of intersecting portions and overlaps the bending portion; or
(ii) the at least one spacer includes a plurality of spacers,
the plurality of spacers comprise a first spacer and a second spacer,
the first spacer is spaced apart from the plurality of intersecting portions and overlaps one of the plurality of first lines and the plurality of second lines, and
the second spacer is spaced apart from the plurality of intersecting portions and overlaps the bending portion.

15. The display device of claim 6, wherein
the at least one spacer includes a plurality of spacers, and
each of the plurality of spacers is spaced apart from each of the plurality of intersecting portions and overlaps one of the plurality of first lines and the plurality of second lines.

16. The display device of any one of claims 1 to 15, wherein:
(i) the at least one spacer comprises an organic material, optionally wherein the organic material comprises polyimide; and/or
(ii) the display device further comprises:
a first dummy layer disposed on the separator and spaced apart from the intermediate layer of each of the plurality of light emitting devices, the first dummy layer and the intermediate layer of each of the light emitting devices including a same material; and
a second dummy layer disposed on the first dummy layer and spaced apart from the second electrode of each of the plurality of light emitting devices, the second dummy layer and the second electrode of each of the plurality of light emitting devices including a same material; and/or
(iii) the display device further comprises:
a plurality of transistors, each of the plurality of transistors is electrically connected to the second electrode of a corresponding one of the plurality of light emitting devices and
a plurality of connection wirings, each of the plurality of connection wirings electrically connecting a corresponding one of the plurality of transistors to the second electrode of a corresponding one of the plurality of light emitting devices
wherein each of the plurality of connection wirings comprises:
a light emitting connection part electrically connected to a corresponding second electrode of one of the plurality of light-emitting devices and spaced apart from a corresponding one of the plurality of light emitting openings; and
a driver connection part electrically connected to a corresponding transistor among the plurality of transistors.
